# EUROPÄISCHE PATENTSCHRIFT

(11) **EP 3 363 042 B1**
(45) Veröffentlichungstag und Bekanntmachung des Hinweises auf die Patenterteilung: **27.11.2019**
(21) Anmeldenummer: 16775129.6
(22) Anmeldetag: 22.09.2016
(51) Int. Cl.: H01L 21/677, H01L 21/68, H01L 23/00, H01L 21/67, H01L 21/683, H05K 13/08, H05K 13/02

(54) **EMPFANGSEINRICHTUNG FÜR BAUTEILE**
RECEPTION DEVICE FOR COMPONENTS
DISPOSITIF DE RÉCEPTION POUR COMPOSANTS

(30) Priorität: 16.10.2015 DE 102015013495
(43) Veröffentlichungstag der Anmeldung: 22.08.2018
(73) Patentinhaber: Mühlbauer GmbH & Co. KG, 93426 Roding (DE)
(72) Erfinder: KOCH, Konstantin, 93426 Roding (DE); FERSTL, Markus, 93413 Cham (DE)
(74) Vertreter: Schmidt, Steffen J.
(86) Internationale Anmeldenummer: PCT/EP2016/072479
(87) Internationale Veröffentlichungsnummer: WO 2017/063835

(56) Entgegenhaltungen:
- EP-A1- 1 802 192
- EP-A2- 0 895 450
- WO-A1-03/058708
- CN-A- 103 489 811
- DE-A1-102013 102 046
- US-A- 5 249 356
- US-A- 5 547 537
- US-A1- 2004 163 243
- US-B1- 6 519 838

## Beschreibung

### Hintergrund

Hier wird eine Empfangseinrichtung für Bauteile beschrieben. Diese Empfangseinrichtung ist im Zusammenwirken mit einer Bauteilhandhabungsvorrichtung sowie einem bildgebenden Sensor erläutert.

Ein Bauteil ist hier zum Beispiel ein (elektronisches) Halbleiterbauteil, auch als "chip" oder "die" bezeichnet. Ein solches Bauteil hat in der Regel eine prismatische Gestalt, einen im Wesentlichen polygonalen, zum Beispiel viereckigen (rechteckförmigen oder quadratischen) Querschnitt mit mehreren Mantelflächen sowie eine Stirnfläche und eine Deckfläche. Die Mantelflächen sowie die beiden (untere und obere) Deckflächen des Bauteils sind nachfolgend allgemein als Seitenflächen bezeichnet. Das Bauteil kann auch eine von vier abweichende Anzahl von Mantelflächen haben. Ein Bauteil kann auch eine optisches Bauteil (Prisma, Spiegel, Linse, etc.) sein. Insgesamt kann ein Bauteil jede geometrische Form haben.

Aus der betrieblichen Praxis der Anmelderin sind so genannte Aufnehm- und Absetzvorrichtungen bekannt, in denen Bauteile mittels eines Saugers oder Festhalters von einem Bauteiltisch aufgenommen und anschließend auf einem Träger oder in einem Transportbehälter oder dergl. abgelegt werden. Vor dem Ablegen des Bauteils findet üblicherweise eine Inspektion des Bauteils statt. Dazu werden Abbildungen einer oder mehrerer Seitenflächen des Bauteils mit einer oder mehreren Kameras aufgenommen und mittels automatisierter Bildverarbeitung ausgewertet.

### Stand der Technik

Derartige Festhalter halten ein Bauteil während des Transports und während der Erfassung eines Bildes von einer, zum Beispiel der unteren, Deckfläche des Bauteiles fest. So zeigt die DE 10 2008 018 586 A1 eine optische Erfassungsvorrichtung für die Erfassung von einer Oberfläche eines Bauteils, das von einer ersten zu einer zweiten Arbeitsstation transportiert wird, eine auf mindestens eine erste Oberfläche des Bauteils gerichtete Kamera, eine Lichtquelle, die kurzwellige Lichtstrahlen zur ersten Oberfläche sendet. Eine zweite Lichtquelle sendet langwellige Lichtstrahlen zu mindestens einer zweiten Oberfläche des Bauteils. Die Kamera empfängt die an den Oberflächen reflektierten ersten und zweiten Lichtstrahlen. Die zweite(n) Oberfläche(n) sind gegenüber der/den ersten Oberfläche(n) unterschiedlich orientiert, wie es bei beispielsweise quaderförmigen Bauteilen mit einer Unterseite und insgesamt vier seitlichen Oberflächen der Fall ist.

Die EP 1 470 747 B1 betrifft eine Chipentnahmevorrichtung, ein Chipentnahmesystem, ein Bestückungssystem sowie ein Verfahren zum Entnehmen und Weiterverarbeiten von Chips. Die Chips werden von einem Wafer entnommen und zu einer Übergabeposition transportiert und gleichzeitig gewendet. Diese Chipentnahmevorrichtung zum Entnehmen von Chips von strukturierten Halbleiter-Wafern ist ausgestattet mit einem drehbaren Entnahmewerkzeug zum Entnehmen der Chips von dem Wafer und zum Wenden der entnommenen Chips um 180° um ihre Längs- oder Querachse, und einem drehbaren Wendewerkzeug zum erneuten Wenden der entnommenen Chips um 180° um ihre Längs- oder Querachse, welches mit dem Entnahmewerkzeug zusammenwirkt. Das Entnahmewerkzeug hat eine erste Übergabeposition und das Wendewerkzeug hat eine zweite Übergabeposition, an welchen die Chips zur Weiterverarbeitung an einen Bestückkopf übergebbar sind.

Die EP 0 906 011 A2 betrifft eine Vorrichtung zum Entnehmen und Bestücken von elektrischen Bauelementen auf einem Substrat. Die Vorrichtung umfasst eine drehbare Übergabeeinrichtung, die an einer Aufnahmeposition die elektrischen Bauelemente aus einem Zuführmodul entnimmt und an einer ersten Übergabeposition einem Saugband zur Weiterverarbeitung übergibt. Mittels eines drehbaren Bestücckopfes werden die Bauelemente von dem Saugband aufgenommen und zu einer zweiten Übergabeposition transportiert.

Die WO 02/054480 A1 betrifft eine Vorrichtung zum optischen Inspizieren verschiedener Oberflächen eines zu montierenden Chips. Die Vorrichtung umfasst eine erste, obere Transportscheibe, die dazu eingerichtet ist, die Chips aus einer Zuführeinheit zu entnehmen und zu einer ersten Übergabeposition zu transportieren. Die Chips werden in Saugöffnungen gehalten, welche an der Mantelfläche der oberen Transporttrommel ausgebildet sind, und durch Drehen der oberen Transportscheibe bewegt. Die Vorrichtung weist weiterhin eine entsprechend der oberen Transportscheibe ausgebildete zweite, untere Transportscheibe auf, welche die entnommenen Chips an der ersten Übergabeposition aufnimmt und zu einer zweiten Übergabeposition transportiert. Die Vorrichtung ermöglicht eine Inspektion der Chips, indem seitlich neben den Transportscheiben Kameras angeordnet sind, die die Chips an deren Ober- und Unterseite inspizieren. Die Chips werden weiterhin relativ zur ursprünglichen Ausrichtung ungewendet an eine Sortiervorrichtung zur Weiterverarbeitung übergeben.

Die US 4,619,043 offenbart eine Vorrichtung und ein Verfahren zum Entnehmen und Anbringen von elektronischen Bauteilen, insbesondere Chips, auf einer Leiterplatte. Die Vorrichtung umfasst ein Beförderungsmittel zum Aufnehmen der Chips in Aufnahmeeinheiten und zum Transprotieren der aufgenommenen Chips zu einer ersten Übergabeposition. Das Beförderungsmittel weist dabei eine Beförderungskette und ein drehbares Kettenrad auf, welche zusammen im Eingriff stehen. Die Vorrichtung umfasst weiterhin ein drehbares Befestigungswerkzeug mit Bestückköpfen zum Aufnehmen der Chips an der ersten Übergabeposition. Das Befestigungswerkzeug ist weiterhin dazu eingerichtet, mittels einer Drehbewegung die aufgenommenen Chips zu einer zweiten Übergabeposition zu befördern, wobei sie gewendet werden.

Die JP 2-193813 betrifft eine Vorrichtung zum Aufnehmen und zum Wenden von elektronischen Komponenten, welche durch Prüfvorrichtungen inspiziert werden. Die Vorrichtung umfasst eine Zufuhreinheit, aus welcher chipartige elektronische Bauteile durch einen ersten rotierenden Körper entnommen und an dessen Umfang angeordnet werden. Durch eine Drehbewegung des rotierenden Körpers werden die elektronischen Bauteile zu einer ersten Übergabeposition transportiert, wodurch diese um ihre Längs- oder Querachse gewendet werden. Die Vorrichtung umfasst weiterhin einen zweiten rotierenden Körper, welcher die entnommenen elektronischen Bauteile an der ersten Übergabeposition aufnimmt und zu einer zweiten Übergabeposition transportiert. Dabei erfolgt ein weiteres Wenden der elektronischen Bauteile um deren Längs- oder Querachse. Die Vorrichtung ermöglicht somit, dass unterschiedliche Seiten der Bauteile inspiziert werden.

Die US 6,079,284 betrifft eine Vorrichtung zum umfangreichen visuellen Inspizieren von Tabletten. Die Vorrichtung umfasst eine erste Inspektionstrommel, welche mittels an deren Mantelfläche ausgebildeten Sauglochbohrungen die Tabletten aus einer Zuführvorrichtung entnimmt und diese durch Drehen zu einer zweiten Inspektionstrommel transportiert. Die zweite Trommel ist entsprechend der ersten Trommel mit Sauglochbohrungen ausgebildet, welche die Tabletten an der Übergabeposition aufnehmen. Die Vorrichtung umfasst weiterhin Inspektionseinheiten, welche eine umfassende Inspizierung der Tabletten ermöglichen.

Weiterer technologischer Hintergrund ist den Dokumenten JP 2001-74664 (A), JP 1-193630 (A), US 5,750,979, WO 85/04385 A1, DE 199 13 134 A1, JP 8-227904 A zu entnehmen.

Die WO 03/058708 A1 und die US 5 249 356 A betreffen eine Empfangseinrichtung für Bauteile, um relativ zu einer Ablagestelle mittels eines Drehantriebes um eine die Ablagestelle enthaltende dritte Achse kontrolliert zu drehen, und mittels eines Linearantriebes längs einer der ersten, zweiten und dritten Achsen kontrolliert zu verfahren.

EP 1 802 192 A1 und US 2004/036041 A1 zeigen Empfangseinrichtungen für Bauteile. Wie die Bauteile in diesen Empfangseinrichtungen schneller und genauer ausgerichtet werden können, wird in diesen Dokumenten nicht erörtert.

### Zu lösendes Problem

Eine Empfangseinrichtung für Bauteile soll eine präzise Handhabung von Bauteilen sowie deren Inspektion bei hohem Durchsatz ermöglichen.

### Hier vorgestellte Lösung

Diese Aufgabe löst eine Empfangseinrichtung für Bauteile, die dazu eingerichtet ist, relativ zu einer Ablagestelle mittels eines Drehantriebes zumindest teilweise um eine die Ablagestelle enthaltende dritte Achse kontrolliert zu drehen, und/oder wenigstens mittels eines Linearantriebes zumindest teilweise längs einer der ersten, zweiten und/oder dritten Achsen kontrolliert zu verfahren, und/oder mittels eines Drehantriebes einen durch die Empfangseinrichtung geführten Träger längs einer der ersten und/oder zweiten Achsen kontrolliert zu verfahren.

Der Empfangseinrichtung für Bauteile ist in einer Variante funktional vorgeschaltet eine Bauteilhandhabungsvorrichtung zum Entnehmen von prismatischen Bauteilen von einem strukturierten Bauteilvorrat und zum Ablegen der entnommenen Bauteile an einer Empfangseinrichtung. Eine erste Wendeeinrichtung mit mehreren Aufnehmern ist dazu eingerichtet, an einer Spendestelle ein Bauteil von dem strukturierten Bauteilvorrat zu empfangen, das empfangene Bauteil um einen ersten vorbestimmten Winkel um seine Längs- oder Querachse zu wenden und zu einer Übergabestelle zu fördern. Eine zweite Wendeeinrichtung mit mehreren Aufnehmern ist dazu eingerichtet, das Bauteil an der Übergabestelle von einem Aufnehmer der ersten Wendeeinrichtung zu empfangen, das empfangene Bauteil um einen zweiten vorbestimmten Winkel um seine Längs- oder Querachse zu wenden und zu einer Ablagestelle zu fördern. Den ersten und zweiten Wendeeinrichtungen zugeordnete Lage- und Eigenschaftssensoren sind dazu eingerichtet, Lagedaten der ersten und zweiten Wendeeinrichtungen, Lagedaten von an den Aufnehmern befindlichen Bauteilen, und/oder Eigenschaften von an den Aufnehmern befindlichen Bauteilen zu erfassen, und für eine Steuerung zur Verfügung zu stellen. Die Steuerung ist dazu eingerichtet, mittels eines ersten Drehantriebes die erste Wendeeinrichtung um eine erste Achse kontrolliert zu drehen, mittels eines ersten Linearantriebes die erste Wendeeinrichtung längs der ersten Achse kontrolliert zu verfahren, mittels eines zweiten Drehantriebes die zweite Wendeeinrichtung um eine zu der ersten Achse nicht kollineare zweite Achse kontrolliert zu drehen, und mittels eines zweiten Linearantriebes die zweite Wendeeinrichtung längs der zweiten Achse kontrolliert zu verfahren.

So bildet die hier vorgestellte Anordnung eine integrierte Empfangseinrichtung/Inspektionseinrichtung für Bauteile. Die Begriffe Empfangsstelle und (Ablage-)Tasche werden hier gleichbedeutend verwendet. Schlechtteile können dabei ausgeschleust werden. Die in den Übergabevorgang integrierte optische Untersuchung des Bauteils gliedert sich in mehrere Untersuchungsvorgänge auf. Sie nutzt einen oder mehrere bildgebende Sensoren zum optischen Erfassen von Deck- und/ oder Mantelfläche(n) eines Bauteils sowie der Positionen der Aufnehmer an den Übergabe-/ Empfangsstellen. Diese bildgebenden Sensoren sind dazu eingerichtet, in mehreren Untersuchungsvorgängen jeweils wenigstens ein Bild einer der Deck- und/ oder Mantelflächen eines Bauteils zu erfassen. Die Förderung / der Transport der Bauteile geschieht, während Aufnehmer von Wendeeinrichtungen jeweils ein Bauteil halten. Ein gehaltenes Bauteil passiert während des Transports einzelne Untersuchungsvorgänge. Die erfassten (Bild-)Daten der bildgebenden Sensoren dienen dabei auch dazu, die Positionsregelung der Manipulatoren (Aufnehmer) und der Empfangsstellen zu koordinieren. Die Bauteilförderung ist dazu eingerichtet, ein Bauteil im Wesentlichen kontinuierlich oder getaktet entlang seines Pfades zu fördern.

Die hier vorgestellte komplette Baugruppe vereint funktional zwei Aspekte: Handhabung und Inspektion. Diese beiden Funktionen werden zur schnellen und präzisen qualitativen Beurteilung mehrerer (bis zu sechs oder mehr) Seiten der Bauteile ineinander verwoben, während diese schnell aus dem Bauteilvorrat vereinzelt entnommen und durch die Inspektion als Gutteile klassifiziert an der oder den Empfangsstellen präzise abgesetzt werden.

Die Bauteilhandhabungsvorrichtung hat zwei vorzugsweise geregelt betriebene, vorzugsweise im Wesentlichen orthogonal (90° plus minus bis zu 15°) zueinander angeordnete, in etwa stern- oder radförmige Wendeeinrichtungen. Die Wendeeinrichtungen könnten auch eine rechteckige Gestalt haben. Jede dieser Wendeeinrichtungen trägt mehrere zu ihrer Drehachse radial verfahrbare Aufnehmer, um die Bauteile jeweils auf einem Aufnehmer fixiert innerhalb eines Schwenkwinkels zwischen Bauteil-Übernahme und -Übergabe einer oder mehreren Prozessstationen zur Inspektion, Schlechtteilausschleusung und ggf. weiteren Stationen zuzuführen.

Bei der hier vorgestellten Bauteilhandhabungsvorrichtung tragen die stern- oder radförmigen Wendeeinrichtungen die Bauteile an radial nach außen weisenden Aufnehmern, die am (gedachten) Umfang der beiden Wendeeinrichtungen angeordnet sind. Dies ist im Unterschied zu solchen Bauteilhandhabungsvorrichtungen zu sehen, bei denen die Aufnehmer einer oder beider Wendeeinrichtungen koplanar oder parallel zur deren Rotationsachse orientiert sind.

Während vorstehend mehrere Untersuchungsvorgänge erwähnt sind, soll damit kein zeitlicher Ablauf oder eine Reihenfolge (zuerst eine Bilderfassung in einem ersten und dann eine Bilderfassung in einem weiteren Untersuchungsvorgang) festgelegt sein. Vielmehr sind auch Fälle denkbar, in denen die umgekehrte Reihenfolge günstiger ist. Da abhängig von der Anzahl der Aufnehmer an den einzelnen Wendeeinrichtungen auch gleichzeitig mehrere Bauteile an jeder der Wendeeinrichtungen aufgenommen sein können, finden die Untersuchungsvorgänge auch zeitgleich, wenn auch an unterschiedlichen Bauteilen, statt.

Die in den einzelnen Untersuchungsvorgängen durch die bildgebenden Sensoren erfasste(n) (oberen/unteren) Deck- und/oder (seitlichen) Mantelfläche(n) eines Bauteils können voneinander abweichende Deck- und/oder Mantelflächen des Bauteils sein.

Ein Aspekt der optischen Untersuchung sieht vor, dass die Bauteilförderung mit einem Bauteil den Bauteilpfad im Wesentlichen ohne oder nahezu ohne Stillstand absolviert. Dabei werden während der Bewegung oder während der minimalen Stillstandszeiten eine oder mehrere Deck- und/oder Mantelflächen eines Bauteils mit den bildgebenden Sensoren erfasst. Diese Bilder werden anschließend mit Methoden der Bildverarbeitung ausgewertet. Eine Variante dieser optischen Erfassung / Untersuchung sieht vor, dass als bildgebende Sensoren eine oder mehrere Farb-Kameras oder Schwarzweiß-Kameras vorgesehen sind.

Die bildgebenden Sensoren können dabei einen oder mehrere Spiegel, optische Prismen, Linsen oder dergl. haben.

Den bildgebenden Sensoren können Strahlungs- oder Lichtquellen zugeordnet sein. Dabei kann jede Quelle dazu eingerichtet sein, Licht / Strahlung mit einem unterschiedlichen Spektral- oder Wellenlängenbereich zur Beleuchtung zumindest eines Abschnitts des Bauteils abzugeben. Die Wellenlängenbereiche können zumindest teilweise voneinander abweichen, überlappen oder übereinstimmen. So kann zum Beispiel das Licht der ersten Lichtquelle rot, und das Licht der zweiten Lichtquelle kann blau sein. Es kann aber auch die umgekehrte Zuordnung oder eine andere Wellenlängenpaarung (zum Beispiel infrarotes und sichtbares Licht) gewählt sein.

Die Lichtquellen können durch eine Steueranordnung in dem Moment jeweils kurz eingeschaltet werden, wenn sich der Aufnehmer mit dem Bauteil im jeweiligen Erfassungsbereich befindet, so dass die Deck- und/oder Mantelflächen des Bauteils mit einem kurzen Lichtblitz zur Erfassung durch den jeweiligen bildgebenden Sensor belichtet werden können. Alternativ kann eine dauerhafte Beleuchtung verwendet werden.

Der Bauteilhandhabungsvorrichtung ist in einer Variante eine Abgabeeinrichtung zugeordnet, die dazu eingerichtet ist, jeweils ein Bauteil aus dem strukturierten Bauteilvorrat an einen durch die Steuerung entsprechend positionierten Aufnehmer der ersten Wendeeinrichtung abzugeben. Dies kann ein Bauteil-Ausstoßer (die ejector) sein, der das Bauteil durch die Waferträgerfolie hindurch mittels einer Nadel abstößt oder ein Laserpulsgeber, der den Haftkleber des Bauteils an der Trägerfolie gezielt zum Schmelzen bringt. Der Abgabeeinrichtung ist ein Lage- und/oder Eigenschaftssensor zugeordnet, der dazu eingerichtet ist, die Lage der Abgabeeinrichtung relativ zu dem abzugebenden Bauteil und/oder Lagedaten des abzugebenden Bauteils, und/oder Eigenschaften des abzugebenden Bauteils zu erfassen und für die Steuerung zum Betätigen der Abgabeeinrichtung zur Verfügung zu stellen.

Der Bauteilhandhabungsvorrichtung ist in einer Variante mit einer der Ablagestelle zugeordneten Empfangseinrichtung für ein dorthin gefördertes Bauteil ausgestattet. Der Empfangseinrichtung sind dabei Lage- und/oder Eigenschaftssensoren zugeordnet, die dazu eingerichtet sind, Lagedaten des an die Ablagestelle geförderten Bauteils, Lagedaten und/oder Eigenschaften von Empfangsstellen in der Empfangseinrichtung und/oder darin befindlichen Bauteils zu erfassen und für eine Steuerung zur Verfügung zu stellen. Die Steuerung ist dazu eingerichtet, mittels eines dritten Drehantriebes die Empfangseinrichtung zumindest teilweise um eine die Ablagestelle enthaltende dritte Achse kontrolliert zu drehen. Die Steuerung kann auch dazu eingerichtet sein, die Empfangseinrichtung mittels wenigstens eines dritten Linearantriebes zumindest teilweise längs einer Achse kontrolliert zu verfahren. Schließlich kann die Steuerung auch dazu eingerichtet sein mittels eines Linearantriebes einen durch die Empfangseinrichtung geführten Träger längs einer der ersten und/oder zweiten Achsen kontrolliert zu verfahren. Dieser Träger dient dazu, die Bauteile in vereinzelter Form aufzunehmen.

Bei der Bauteilhandhabungsvorrichtung sind in einer Variante die Aufnehmer der ersten und/oder der zweiten Wendeeinrichtung dazu eingerichtet, radial zur Drehachse oder das Drehzentrum der jeweiligen Wendeeinrichtung kontrolliert aus- und eingefahren zu werden, und/ oder zum Empfangen und Abgeben eines zu fördernden Bauteils kontrolliert mit Unterdruck und/oder Überdruck beaufschlagt zu werden, und/ oder um ihre jeweilige radiale Bewegungsachse unbeweglich zu sein, oder um ihre jeweilige radiale Bewegungsachse um einen Drehwinkel kontrolliert gedreht zu werden.

Bei einer Bauteilhandhabungsvorrichtung dieser Art sind in einer Variante den Aufnehmern der ersten und/oder der zweiten Wendeeinrichtung zum radialen Aus-/Einfahren bei der Spendestelle, der Übergabestelle zwischen den ersten und zweiten Wendeeinrichtungen diesen zugeordnete Linearantriebe vorgesehen. Diese Linearantriebe greifen in die entsprechend positionierten Aufnehmer jeweils von außerhalb der jeweiligen Wendeeinrichtungen ein und fahren den jeweiligen Aufnehmer radial aus- und ein. In einer anderen Variante fahren diese Linearantriebe den jeweiligen Aufnehmer lediglich aus, während eine Rückstellfeder den jeweiligen Aufnehmer einfährt. In einer weiteren Variante ist jedem der Aufnehmer ein bidirektionaler oder unidirektionaler Radialantrieb zugeordnet.

In einer Variante der Bauteilhandhabungsvorrichtung stellen Ventile zu jedem der einzelnen Aufnehmer individuell und positionsgerecht eine Zuführung von Unterdruck und Überdruck bereit um frei oder positionsgesteuert die Funktionen: (i) Ansaugen des Bauteils, (ii) Halten des Bauteils, (iii) Ablegen des Bauteils mit oder ohne gesteuertem Abblas-Impuls, und/oder freies Abblasen des Bauteils zu realisieren.

In einer Variante der Bauteilhandhabungsvorrichtung sind der ersten Wendeeinrichtung zwischen der Spendestelle und der Übergabestelle, und/oder der zweiten Wendeeinrichtung zwischen der Übergabestelle und der Ablagestelle jeweils Lage- und Eigenschaftssensoren zugeordnet. Diese Sensoren sind dazu eingerichtet, Lagedaten und/oder Eigenschaften des geförderten Bauteils und/oder Positionsdaten zur Lageregelung der Manipulatoren (Aufnehmer) und der Empfangsstellen zu erfassen und für die Steuerung zur Verfügung zu stellen.

In einer Variante der Bauteilhandhabungsvorrichtung sind wenigstens einige der Lage- und Eigenschaftssensoren dazu eingerichtet, jeweils wenigstens eine Deckfläche und/oder eine oder mehrere Mantelflächen des geförderten Bauteils zu inspizieren um dessen Lagedaten und/oder Eigenschaften zu erfassen und für die Steuerung zur Verfügung zu stellen.

In einer Variante der Bauteilhandhabungsvorrichtung sind im Zentrum der ersten Wendeeinrichtung und/oder im Zentrum der der zweiten Wendeeinrichtung jeweils ein bildgebender Eigenschafts- und/oder Lagesensor zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils vorgesehen. Basierend auf den Eigenschaftsdaten und/oder den Lagedaten des Sensors / dieser Sensoren kann dann eine Korrektur bei Eigenschaftsfehlern und/oder Lagefehlern des zu empfangenden Bauteils bzw. der Empfangsstelle durch die Steuerung erfolgen. Dabei ist/sind der/die bildgebende/n Lagesensor/en dazu eingerichtet, einen Bildeinzug jeweils während der Wendebewegung der ersten bzw. zweiten Wendeeinrichtung zwischen benachbarten Aufnehmern auszuführen und für die Steuerung zur Veranlassung entsprechender Korrekturbewegungen der Ausstoßeinheit, dem Bauteilvorrat oder Wafer, der Wendeeinrichtungen und/oder der Empfangseinrichtung zur Verfügung zu stellen. In einer anderen Variante ist die Ausstoßeinheit feststehend.

Zusätzlich oder alternativ zu diesen bildgebenden Eigenschafts- und/oder Lagesensoren können relativ zu den ersten und zweiten Wendeeinrichtungen extern vorgesehene bildgebende Eigenschafts- und/oder Lagesensoren zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils vorgesehen sein. Basierend auf den Eigenschaftsdaten und/oder den Lagedaten dieses Sensors / dieser Sensoren kann dann eine Korrektur bei Eigenschaftsfehlern und/ oder Lagefehlern des zu empfangenden Bauteils bzw. der Empfangsstelle durch die Steuerung erfolgen. Unabhängig von dem vorstehend beschriebenen Inspektionssystem und funktional als Bestandteil dem Handhabungssystem zuzuordnen, können jeweils im Zentrum der beiden Wendeeinrichtungen eine nach oben gerichtete Bauteilvorrats-Kamera (mit 90°-Spiegelsystem und Beleuchtung) bzw. eine bevorzugt aber nicht zwingend baugleiche nach unten gerichtete Baugruppe als Ablege-Kamera angeordnet sein. Sie dienen zur Positionserfassung der Bauteile bzw. der Empfangsstellen mit dem Ziel der Positionskorrektur bei auftretenden Lagefehlern der Bauteile bzw. der Empfangsstellen. Der Bildeinzug erfolgt jeweils während der Schwenkbewegung der beiden Wendeeinrichtungen durch einen Fensterbereich zwischen den Aufnehmern mit anschließender Wafer - bzw. Empfangseinrichtungs-Korrekturbewegung. Hier sind auch Alternativen mit extern gelagerten Wafer- bzw. Ablege-Kameras möglich.

In einer Variante der Bauteilhandhabungsvorrichtung ist der Übergabestelle und/oder der Ablagestelle eine Ausschleusstelle vor- oder nachgelagert, die dazu eingerichtet ist, durch die Steuerung gesteuert, ein durch die Steuerung mittels wenigstens eines der Lage- und Eigenschaftssensoren als Schlechtteil erkanntes Bauteil auszuschleusen, und es nicht als Gutteil in die Empfangseinrichtung abzulegen.

In einer Variante der Bauteilhandhabungsvorrichtung sind der ersten und/oder der zweiten Wendeeinrichtung jeweils eine ganzzahlige Anzahl von n Aufnehmern zugeordnet. Dabei gilt n >= 2. Die Anzahl der Aufnehmer der ersten Wendeeinrichtung und die Anzahl der Aufnehmer der zweiten Wendeeinrichtung können dabei gleich oder unterschiedlich sein.

In einer Variante der Bauteilhandhabungsvorrichtung schließen die ersten, zweiten und/oder dritten Achsen zueinander jeweils einen Winkel von 90° plus/minus maximal 10° oder 15° ein.

In einer Variante der Bauteilhandhabungsvorrichtung sind die Lage-/Eigenschaftssensoren bildgebende Sensoren mit übereinstimmenden oder voneinander abweichenden Erfassungsspektren, oder berührend oder berührungslos distanzmessende Lagesensoren, oder berührend oder berührungslos erfassende Eigenschaftssensoren.

Die Lage- und Eigenschaftssensoren können bildgebende Sensoren mit geradlinigen oder abknickenden optischen Achsen sein.

Die Kamera-Systeme der Lage- und Eigenschaftssensoren einschließlich ihrer Spiegel- und Beleuchtungseinheiten können durch ihre räumliche Anordnung derart kombiniert sein, dass die Bauteil-Inspektion der jeweils zugewandten Bauteilfläche und zweier seiner Mantelflächen parallelisiert an einer einzigen Prozessposition realisierbar ist. Insgesamt genügen zwei Prozesspositionen zur kompletten Inspektion aller sechs Seitenflächen eines zum Beispiel quaderförmigen Bauteils. Dazu werden an jeder der beiden Prozesspositionen von dem Bauteil drei der sechs Seitenflächen erfasst. Als Inspektionsposition einer jeden Wendeeinrichtung kann in einer Variante dabei die jeweils dritte Prozessposition in etwa horizontal auf Höhe der Rotations- oder Schwenkachse festgelegt sein.

Zusätzliche positionsmessende Aufgaben können zwei weiteren Kamera-Systemen (Vorder-/Rückseiten-Kamera) zugeordnet sein.

In einer Variante der Bauteilhandhabungsvorrichtung sind die ersten und/oder zweiten Wendeeinrichtungen zumindest annähernd stern- oder radförmig ausgestaltet. Die Wendeeinrichtungen können präzisionsgelagert sein und ihre Positionierung längs der jeweiligen Achsen bzw. um die jeweiligen Achsen kann mittels axial angeordnetem linear bzw. rotatorisch wirkendem Antrieb erfolgen, gepaart mit einem hochauflösenden (zum Beispiel rotatorischen oder linearen) Encoder. Die jeweiligen Aufnehmer können am äußeren Umfang verteil angeordnet sein und radial nach außen weisende Saugkontaktstellen für die zu fördernden Bauteile haben.

Ein Vorteil der axial um etwa 90° versetzten Anordnung der Wendeeinrichtungen zueinander besteht darin, dass die Bauteile in ihrer Lage während des Förder-Prozesses bei Übergabe von einer Wendeeinrichtung zur nächsten eine 90°-Drehung um die Aufnehmerachse, relativ zur jeweiligen Bewegungsebene der Aufnehmer (bzw. Wendeeinrichtung-Achse) ausführen, ohne, dass dafür der Aufnehmer selbst rotatorisch verfahrbar gelagert werden muss. Diese Orientierungsänderung der Bauteile ermöglicht wiederum eine wesentliche vereinfachte Inspektion der vier Bauteil-Schnittflächen (=Bauteilseitenflächen). Hierfür dient ein durch je ein, der Bauteil-Schnittfläche zugewandtes, orthogonal zur Aufnehmer-Bewegungsebene (also in axialer Richtung der Wendeeinrichtung) angeordnetes Kamera-System mit vorzugsweise sehr geringem Abstand zu den Bauteil-Schnittflächen (= Mantelflächen des Bauteils) selbst.

Die Erfassung der Fehlpositionierung von Aufnehmer und Bauteil zueinander bzw. zu den Übergabe- und Inspektionspositionen erfolgt unter Nutzung der Kamera- Systeme als Aufnehmer- bzw. Bauteil-Lage-erfassendes Messsystem. Bei sehr hohen Genauigkeitsanforderungen können zusätzlich jeweils drei distanzmessende Sensoren für die Bondtool-Lageerfassung je Wendeeinrichtung zusätzlich vorgesehen sein.

Die optischen Achsen der Kameras "durchdringen" die inspizierte Bauteil-Oberfläche. Sie bilden ein Bezugssystem für die Aufnehmer-Lage. Hiervon abgeleitet lassen sich durch die in einer Ebene parallel zur idealen Aufnehmer-Bewegungsebene der rotierenden Wendeeinrichtung angeordneten distanzmessenden Sensoren Abweichungen der Aufnehmer-Bewegungsbahn von der Soll-Bewegungsbahn ermitteln. Daraus sind die auftretenden Positionsfehler in den Übergabepositionen bestimm- und durch die Steuerung kompensierbar.

Je nach Funktionsprinzip der zusätzlichen Lagesensoren lassen sich die Referenzmessungen zur Aufnehmer-Lage im laufenden Prozess oder auch während zyklisch sich wiederholender Referenzfahrten (zum Beispiel mittels tastend berührender Messsensoren erforderlich) realisieren. Dafür sind sowohl zu Prozessbeginn zur Erfassung räumlicher Lagefehler, als auch während des Prozesses zur Einbeziehung thermisch bedingter Verlagerungen zyklische Referenzfahrten (bei berührenden Sensoren mit kurzzeitiger Prozessunterbrechung) erforderlich, wobei letztere auch relativ lang sein können.

In einer Variante wird zur Kompensation von Positionsfehlern der Wendeeinrichtungen der Aufnehmer insbesondere in den Bauteil-Übergabepositionen und der darauf fixierten Bauteile (in Übergabe und Inspektionspositionen) eine rotatorische Korrekturbewegung des Rotorantriebes und orthogonal eine lineare Korrekturbewegung in Achsrichtung ausgeführt. Hierfür kann in einer Variante die Rotor-Antriebsbaugruppe auf einem Verfahrschlitten angeordnet sein und mittels eines positionsgeregelten Antriebes, zum Beispiel eines Exzenterantriebes um begrenzte Wegsegmente verfahren werden.

In einer Variante der Bauteilhandhabungsvorrichtung erfordert die starre Kopplung mehrerer Aufnehmer an einer Wendeeinrichtung eine Übertragung der Korrekturwerte von einer Bauteil-Übergabe-Position bzw. Inspektionsposition zu den in der Abfolge nächsten Positionen. Diese Korrekturen können an einer fixen Übergabeposition beginnen und bei der letzten Bauteil-Übergabe in die Empfangsstelle enden. Dabei werden die summarischen Lagefehler entlang der bis zu drei Achsen und die Verdrehung um die bis zu drei Achsen durch die Empfangseinrichtung kompensiert.

In einer Variante der Bauteilhandhabungsvorrichtung sind die Aufnehmer an ihrer jeweiligen Wendeeinrichtung nicht drehbar gelagert. So kann ein Orientierungsfehlerausgleich von Bauteilen während des Förderns selbst nicht erfolgen. Daher ist in einer Variante im nachgelagerten Peripheriebereich, insbesondere in der Empfangseinrichtung neben der Achsen-Lagekorrektur auch eine rotatorische Korrekturmöglichkeit vorzusehen.

In einer anderen Variante der Bauteilhandhabungsvorrichtung erfolgt die Rotationskorrektur mit drehbar gelagerten Aufnehmern. Damit kann ein Ausgleichen von Orientierungsfehlern von Bauteilen während des Förderns selbst erfolgen. Der Orientierungsfehler wird dann durch die drehbar gelagerten Aufnehmer der oberen und/oder unteren Wendeeinrichtung korrigiert, bevorzugt durch die Aufnehmer der unteren Wendeeinrichtung.

Die hier vorgestellten Varianten sind im Vergleich zum Stand der Technik kostengünstiger und bieten einen höheren Bauteiledurchsatz, mehr Zeit für Inspektionen und haben weniger bewegte Massen.

Genauer wird eine Lösung für eine Empfangseinrichtung, insbesondere für eine Bauteilhandhabungsvorrichtung der oben vorgestellten Art vorgestellt, die dazu eingerichtet ist, relativ zu der Ablagestelle mittels eines Drehantriebes zumindest teilweise um eine die Ablagestelle enthaltende dritte Achse kontrolliert zu drehen, und/oder mittels wenigstens eines Linearantriebes zumindest teilweise längs einer der ersten, zweiten und/oder dritten Achsen kontrolliert zu verfahren, und/oder mittels eines Drehantriebes einen durch die Empfangseinrichtung geführten Träger längs einer der ersten und/oder zweiten Achsen kontrolliert zu verfahren.

Die hier vorgestellte Lösung erlaubt, die Position und Lage der Wendeeinrichtungen simultan durch Position und/oder Rotation der Empfangseinrichtung zu kompensieren. Deshalb kann der Bauteiledurchsatz der Maschine gegenüber dem Stand der Technik erhöht werden. Um Spiel im Bandantrieb des Ablagebandes zu vermeiden, müssen im Stand der Technik die Antriebe relativ zueinander eingestellt werden. Die hier vorgestellte Lösung vermeidet dies, da der Transport immer nur in eine Richtung erfolgt. Dies ist insbesondere in Anwendungen hilfreich, bei denen die Taschen des Trägerbandes mit einem klebenden Abdeckband nach und nach verschlossen werden. Würde man das Trägerband wieder zurücktransportieren, ergäben sich evtl. Probleme, wenn das Abdeckband wieder abzulösen wäre. Das Spiel im Antrieb kann dabei vernachlässigt werden.

In einer anderen Variante kann auch in die entgegengesetzte Richtung transportiert werden.

Die Korrektur der Position des Bauteils erfolgt an der Empfangseinrichtung. So steht mehr Zeit dafür zur Verfügung. Ein Rück-Transport des Bandes, in dem die Bauteile abgelegt werden, ist nicht mehr erforderlich. Damit kann die Empfangseinrichtung einfacher aufgebaut sein. Ein zweites Antriebsrad für den Rücktransport des Bandes wie beim Stand der Technik ist nicht mehr erforderlich. Vielmehr wird in den erforderlichen Situationen die gesamte Empfangseinrichtung entgegen der Transportrichtung des Ablagebandes bewegt. Der Vorteil ist, dass eine höhere Positioniergenauigkeit des Bandes gegenüber vorbekannten Varianten erreicht wird, in denen die Positionierung ausschließlich über den Transport des Transportbandes bewerkstelligt wird. Auch das nachfolgende Anbringen eines (selbstklebenden) Abdeckbandes (Cover-Tape) auf dem Transportband kann hierbei leichter erfolgen.

In einer Variante ist die Empfangseinrichtung oberhalb einer ortsfesten Grundplatte angeordnet, die Motoren der drei Antriebe sind unterhalb der Grundplatte angeordnet. Die Position der Empfangseinrichtung kann in X, Y und um die Z-Achse rotierend justiert werden. Jede Bewegungsrichtung der Empfangseinrichtung verfügt über einen eigenen Antrieb. Die Position der einzelnen Antriebe ist nicht festgelegt. Die Drehachse für die Z-Korrektur liegt nahe bei der Bauteil-Ablageposition oder fällt in deren Zentrum.

In einer Variante der Empfangseinrichtung ist diese mit zwei Empfangsstellen ausgestattet, welche zu der Ablagestelle durch kontrolliertes Betätigen des Drehantriebes des/der Linearantriebe zumindest annähernd fluchtend auszurichten sind. Die zwei Empfangsstellen sind einem Rastermaß benachbarter Bauteil-Aufnahmen des Trägers entsprechend zueinander zu positionieren.

In einer Variante der Empfangseinrichtung ist ein bildgebender Eigenschafts- und/ oder Lagesensor zum Ermitteln von Eigenschaften und/oder der Lage eines zu empfangenden Bauteils in Bezug auf dessen Eigenschaften und/oder seiner Lage zu wenigstens einer der Empfangsstellen in der Empfangseinrichtung vorgesehen. Dieser bildgebende Eigenschafts- und/ oder Lagesensor befindet sich im oder beim Zentrum der unteren Wendeeinrichtung. Mit den Bilddaten aus diesem Sensor kann die Erzeugung von Korrekturanweisungen bei Eigenschafts- und/oder Lagefehlern des zu empfangenden Bauteils bzw. der Empfangsstelle durch die Steuerung zur Veranlassung entsprechender Korrekturbewegungen erfolgen.

In einer anderen Variante sind zwei weitere bildgebende Eigenschafts- und/ oder Lagesensoren bei der Empfangseinrichtung vorgesehen. Der eine Sensor ist von oben auf das zweite Fenster gerichtet um Qualitätsfehler zu untersuchen. Der andere Sensor ist beim ersten Fenster seitlich angeordnet um ein Verkippen des Bauteils besser gegenüber dem oben erläuterten Sensor detektieren zu können.

In einer Variante der Empfangseinrichtung ist der vierte Drehantrieb dazu eingerichtet, durch Steuersignale aus der Steuerung angesteuert, mittels einer mechanischen Traktion den durch die Empfangseinrichtung geführten Träger längs einer der ersten und/oder zweiten Achsen kontrolliert um etwa 80 - 120%, vorzugsweise etwa 100% plus minus maximal 3%, des Rastermaßes benachbarter Bauteil-Aufnahmen des Trägers zu verfahren. Dabei kann auch der Drehantrieb dazu eingerichtet sein, durch Steuersignale aus der Steuerung angesteuert, in Abhängigkeit von Signalen aus dem bildgebenden Eigenschafts- und/oder Lagesensor wenigstens eine der Empfangsstellen mit der dort befindlichen Bauteil-Aufnahme des Trägers um die die Ablagestelle enthaltende dritte Achse kontrolliert um bis zu plus minus 6 °, vorzugsweise um bis zu plus minus 3 ° zu drehen. Des Weiteren kann ergänzend oder alternativ der wenigstens eine Linearantrieb dazu eingerichtet sein, durch Steuersignale aus der Steuerung angesteuert, die Empfangseinrichtung kontrolliert um etwa plus minus maximal 20%, vorzugsweise um bis zu plus minus 3% des Rastermaßes benachbarter Bauteil-Aufnahmen des Trägers längs einer der ersten, zweiten und/oder dritten Achsen kontrolliert zu verfahren.

In einer Variante der Empfangseinrichtung ist der vierte Drehantrieb dazu eingerichtet, den durch die Empfangseinrichtung geführten Träger entsprechend einem Rastermaß benachbarter Bauteil-Aufnahmen des Trägers längs einer der ersten und/oder zweiten Achsen vorwärts zu fördern.

In einer Variante der Empfangseinrichtung ist eine Absaug- und/oder Ausblaseinrichtung vorgesehen, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen.

Im Betrieb einer Variante der Empfangseinrichtung greift ein durch den vierten Drehantrieb angetriebenes Stachelrad in Transportlöcher des Ablagebandes für dessen Transport in Förderrichtung ein. Das Stachelrad dreht dabei bevorzugt nur in eine Vorwärts-Richtung. Das Ablageband hat in regelmäßigen Abständen Ablagetaschen für die Bauteile. Pro Ablagetasche dreht das Stachelrad um einen festen Winkelbetrag (z.B. 30°, 60°, 90°, 180° ..., 360°). Aus der Bildaufnahme durch die Kamera im Zentrum der zweiten Wendeeinrichtung ist die Lage der Ablagetasche bekannt, in welche das Bauteil abgelegt wurde. Durch die Kamera am Außenumfang der zweiten Wendeeinrichtung ist überdies bekannt, ob das nächste abzulegende Bauteil am Aufnehmer verdreht gehalten wird. Aus diesen Lageinformationen wird in der Steuerung errechnet, um welche Strecken- und/oder Winkel-Beträge die Empfangseinrichtung umpositioniert werden muss. Außerdem wird bei der Positionierung der Empfangseinrichtung auch berücksichtigt, dass sich die Wendeeinrichtung in x- und y-Richtung entsprechend bewegen wird, um das Bauteil an der Übergabeposition von der oberen zur unteren Wendeeinrichtung korrekt zu übernehmen. Die Empfangseinrichtung wird dann, soweit notwendig, entlang der (X-, Y-)Achsen linear verfahren und ggf. rotiert um die Feinjustierung der Ablage des Bauteils sicherzustellen.

Wenn ein Bauteil in der Ablageposition abgelegt wurde, hat die Kamera im Zentrum der darüber angeordneten zweiten Wendeeinrichtung auch erfasst, ob das Bauteil fehlerhaft ist, d.h. ob es durch das Ablegen beschädigt wurde oder schon vorher einen Defekt hatte. Sofern bereits vorher ein Bauteil als defekt erkannte wurde, wird es nicht abgelegt.

Die Ablageposition in der Empfangseinrichtung kann gleichzeitig auch eine erste Absaugposition sein. Dazu ist an der Empfangseinrichtung ein Absauger mit Unterdruck an der Ablageposition angeordnet. In Förderrichtung des Trägerbandes gibt es eine zweite alternative Absaugposition. Das heißt, an der Empfangseinrichtung sind zwei Fenster vorgesehen: ein erstes Fenster mit einer Ablageposition und ein zweites Fenster mit einer Absaugposition. Der Abstand zwischen beiden Fenstern entspricht dem Rastermaß des Trägerbandes und ist auf das Rastermaß einstellbar. Wurde das Bauteil nicht korrekt abgelegt, so dass es schräg darin liegt, oder noch teilweise herausragt, wird dies durch eine Kamera im Zentrum der zweiten Wendeeinrichtung erkannt. Das Trägerband kann aufgrund des nicht korrekt abgelegten Bauteils nicht weitertransportiert werden. Deshalb wird das Bauteil an der Ablageposition abgesaugt und durch das nächste abzulegende Bauteil ersetzt. Ist das Bauteil beschädigt, kann es an dieser Position ebenfalls entfernt und durch das nächste abzulegende Bauteil ersetzt werden. An der Position des zweiten Fensters kann - ggf. mit einer weiteren Kamera - auf Fehler inspiziert werden. Bei einem als defekt erkanntem Bauteil wird die Empfangseinrichtung insgesamt zurückbewegt und an das als defekt erkannte Bauteil an der Ablageposition abgesaugt.

Alternativ kann die zweite Absaugposition verwendet werden, um das als defekt erkannte Bauteil zu entfernen.

Mit der hier vorgestellten Anordnung ist es möglich, ein Bauteil zur Erkennung von Fehlern zu inspizieren. Das Bauteil ist mit der ersten und zweiten Wendeeinrichtung abzulegen, und ein als defekt erkanntes Bauteil an der Ablageposition zu entfernen. Dies erfolgt an einer gemeinsamen Position.

Die Empfangseinrichtung bewegt sich in drei Richtungen: In X-, und Y-Richtung, und um ihre (Z-)Hochachse im / nahe dem Zentrum der Ablageposition. Dies ist auch im Unterschied zu herkömmlichen Anordnungen zu sehen, bei denen das Trägerband in Transportrichtung gefördert wird und die Empfangseinrichtung senkrecht zur Bandtransportrichtung für die Positionierung zur Bauteilablage bewegt wird. Die Ablegestelle kann auch in Gestalt einer Schale (eines Trays, z.B. Jedec-Tray,) oder als Antennenbahn vorliegen.

In einer alternativen Variante ist der Empfangseinrichtung eine Absaug- und/oder Ausblaseinrichtung zugeordnet, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen.

Die Empfangseinrichtung kann in einer Variante Bauteile von einer Wendeeinrichtung empfangen, deren Drehachse im Wesentlichen parallel zur Förderrichtung der Empfangseinrichtung orientiert ist, oder die Empfangseinrichtung kann in einer weiteren Variante Bauteile von einer Wendeeinrichtung empfangen, deren Drehachse im Wesentlichen quer zur Förderrichtung der Empfangseinrichtung orientiert ist.

Im Zentrum der Wendeeinrichtung ist in einer Variante ein bildgebender Eigenschafts- und/oder Lagesensor zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils vorgesehen. Dieser bildgebende Eigenschafts- und/oder Lagesensor ist dazu eingerichtet, zwischen am Umfang der Wendeeinrichtung befindlichen benachbarten Aufnehmern hindurch Bildeinzüge wenigstens einer der Empfangsstellen in der Empfangseinrichtung auszuführen.

In einer alternativen Variante ist im Zentrum der Wendeeinrichtung ein Umlenkspiegel oder Prisma angeordnet, der dem außerhalb der Wendeeinrichtung angeordneten bildgebenden Eigenschafts- und/oder Lagesensor zugeordnet ist, zum Ermitteln von Eigenschaften und/ oder der Lage eines zu empfangenen Bauteils bzw. zum Ermitteln der Lage von Empfangsstellen in der Empfangseinrichtung und/oder darin befindlichen Bauteils. Der Umlenkspiegel oder das Prisma zusammen mit dem außerhalb der Wendeeinrichtung angeordneten bildgebenden Eigenschafts- und/oder Lagesensor sind dazu eingerichtet, zwischen am Umfang der Wendeeinrichtung befindlichen benachbarten Aufnehmern hindurch Bildeinzüge wenigstens einer der Empfangsstellen in der Empfangseinrichtung auszuführen.

Die Empfangseinrichtung ist relativ zu einer Ablagestelle mittels eines Linearantriebes zumindest teilweise längs einer ersten Achse kontrolliert in beide Richtungen zu verfahren. Mittels eines Drehantriebes ist ein durch die Empfangseinrichtung geführter Träger längs einer der ersten und/oder zweiten Achsen kontrolliert in einer Förderrichtung des Trägers zu verfahren. Der durch die Empfangseinrichtung geführte Träger ist mit zwei Empfangsstellen ausgestattet, welche zu einer Ablagestelle für Bauteile durch kontrolliertes Betätigen der Antriebe zumindest annähernd fluchtend auszurichten sind. Ein bildgebender Eigenschafts- und/ oder Lagesensor liefert Eigenschaften und/oder Lage eines in Bezug auf dessen Eigenschaften und/oder seine Lage zu untersuchendes Bauteil in wenigstens einer der Empfangsstellen in der Empfangseinrichtung. Basierend auf Bilddaten aus dem Eigenschafts- und/ oder Lagesensor erfolgen Korrekturanweisungen bei Eigenschafts- und/oder Lagefehlern des Bauteils durch eine Steuerung zur Veranlassung entsprechender Korrekturbewegungen der Empfangseinrichtung und/oder des in ihr geführten Trägers. Der Empfangseinrichtung ist eine Absaug- und/oder Ausblaseinrichtung zugeordnet, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen.

Ein Verfahren zum Entnehmen fehlerhafter Bauteile aus einer Empfangseinrichtung insbesondere der vorstehend beschriebenen Bau-/Funktionweise weist folgende Schritte auf:
Erfassen eines nicht korrekt abgelegten Bauteils in einer Tasche des Trägers für ein Bauteil an der ersten Empfangsstelle,
Bewegen der Empfangseinrichtung mittels eines Linearantriebes längs der Förderrichtung, so dass das nicht korrekt abgelegte Bauteil sich an der zweiten Empfangsstelle befindet, ohne dabei den in der Empfangseinrichtung geführten Träger zu fördern,
Absaugen des nicht korrekt abgelegten Bauteils an der zweiten Empfangsstelle aus der Tasche für ein Bauteil;
Zurückbewegen der Empfangseinrichtung mittels des Linearantriebes entgegen der Förderrichtung, so dass das eine leere Tasche für ein Bauteil sich an der ersten Empfangsstelle befindet, ohne dabei den in der Empfangseinrichtung geführten Träger zu fördern,
Ablegen eines Bauteils in der Tasche des Trägers an der ersten Empfangsstelle.

Aufgrund gestiegener Qualitätsanforderungen bei gleichzeitig sinkenden Abmessungen elektronischer Bauteile, die überdies in stets sinkenden Prozesszeiten zu verarbeiten sind, wurden die herkömmlichen Sensoranordnungen als nicht ausreichend erkannt.

Als eine Variante wird daher ein bildgebender Sensor vorgeschlagen, der geeignet und bestimmt ist zur Erfassung von Lage- und/oder Eigenschaften eines Bauteils, insbesondere in einer Bauteilhandhabungsvorrichtung der vorstehend offenbarten Art. Dieser bildgebende Sensor ist mit wenigstens zwei voneinander abweichenden Erfassungsspektren ausgestattet. Er ist insbesondere geeignet und bestimmt zur Erfassung von Eigenschaftsfehlern und/oder Lagefehlern eines in der Empfangsstelle einer Empfangseinrichtung befindlichen Bauteils. Dieser bildgebende Sensor ist geeignet und bestimmt, mit Strahlungsquellen zusammenzuwirken, die hinsichtlich Strahlungsspektrum und Strahlungsauftreffwinkel und/oder Strahlungsreflexionswinkel relativ zu dem bildgebenden Sensor auf diesen abgestimmt sind. Der bildgebende Sensor ist geeignet und dazu eingerichtet, für jedes seiner Erfassungsspektren einer ihm nachgeordneten Bildauswertung einen separaten Bildeinzug bereitzustellen.

Bei diesem bildgebenden Sensor sind beispielsweise die wenigstens zwei voneinander abweichenden Erfassungsspektren im sichtbaren und nicht sichtbaren Bereich ausgestaltet. Sie können auch als roter Farbbereich - 630nm plus minus 30 nm -, und/ oder grüner Farbbereich - 530 nm plus minus 60 nm -, und/oder blauer Farbbereich - 460nm plus minus 50 nm - eines Farbsensors ausgestaltet sein.

In einer Variante des bildgebenden Sensors sind optisch wirksame Elemente vorgesehen, die dazu eingerichtet sind, den Sensor mit einem Bauteil in wenigstens einer der Empfangsstellen in der Empfangseinrichtung und/oder dem in der Empfangseinrichtung geführten Träger optisch zu koppeln.

In einer Variante des bildgebenden Sensors umfassen die optisch wirksamen Elemente Umlenkspiegel, Prismen, Farbfilter und/oder Linsen.

Einzelne der optisch wirksamen Elemente und/oder der Strahlungsquellen können dazu eingerichtet sein, unabhängig von anderen aktiviert, ausgerichtet und/oder justiert / fokussiert zu werden.

Die hier offenbarte integrierte Handhabungs-/Inspektionseinrichtung verwendet bildgebende Sensoren, die einerseits alle oder fast alle Deck- und/oder Seitenfläche(n) eines Bauteils inspizieren und dabei andererseits auch relevante Daten zur Positionierung der Manipulatoren (Aufnehmer) an der ersten und/oder der zweiten Wendeeinrichtung und der Empfangsstellen liefern.

Der bildgebende Sensor der ersten (oberen) Wendeeinrichtung ist in einer Variante eine Farbkamera im Zentrum der Wendeeinrichtung. Alternativ kann die Kamera auch eine Schwarz/Weiß-Kamera sein, die in einer weiteren Variante seitlich und mit einem 45° - Umlenkspiegel im Zentrum der Wendeeinrichtung zusammenwirkt. Diese Kamera erfasst während der Rotation der oberen Wendeeinrichtung durch den Spalt zwischen zwei Aufnehmern das im nächsten Schritt von dem Bauteil-Ausstoßer aus dem Bauteilvorrat vereinzelte Bauteil. Aus dem dabei gewonnenen Bildeinzug ist sowohl eine Inspektion des Bauteils als dessen exakte Positionsbestimmung im Bauteilvorrat möglich. Der Bildeinzug findet während der Rotation der oberen Wendeeinrichtung, in dem als Blickfenster bezeichneten Zeitraum statt.

Die hier offenbarte integrierte Handhabungs-/Inspektionseinrichtung verwendet außerdem bildgebende Sensoren in Form von seitlichen Kameras an der oberen Wendeeinrichtung. Diese sind etwa bei 90° radial außerhalb der oberen Wendeeinrichtung derart angeordnet, dass das Bauteil auf seinem Flugkreis von einer mittleren Kamera frontal erfasst wird und von den zu beiden Seiten der mittleren Kamera jeweils einander gegenüberliegende Mantelfläche erfasst werden. Diese Kameras sind nicht zwingend Farbkameras. Es können mehrere Bildeinzüge angefertigt werden, weil die obere Wendeeinrichtung kurzzeitig (10ms bis 60 ms, zum Beispiel 40 ms) jeweils wegen der nachfolgenden Bauteilübergabe in der 180° Position still steht. Dieser kurze Stillstandszeitraum ist ausreichend für die Inspektion. Dazu können auch Schwarz/Weiß-Kameras eingesetzt sein. Mit der Seiteninspektion durch die beiden seitlichen Kameras werden die Stirnseiten des Bauteils auf Beschädigungen untersucht. Mit der Rückseiteninspektion durch die mittlere Kamera wird die Bauteilrückseite auf Beschädigungen untersucht. Für die Rückseiteninspektion können mehrere Bildeinzüge durchgeführt werden um verschiedene Defekte hervorzuheben. Bei den hier verwendeten Kameras kann es sich ebenfalls um Farbkameras handeln. Dies ist jedoch nicht zwingend erforderlich, da wie oben bereits erwähnt aufgrund des Stillstandszeitraums ausreichend Zeit zur Verfügung steht.

Die hier offenbarte integrierte Handhabungs-/Inspektionseinrichtung verwendet außerdem bildgebende Sensoren in Form von seitlichen Kameras an der unteren Wendeeinrichtung. Diese sind etwa bei 90° radial außerhalb der unteren Wendeeinrichtung derart angeordnet, dass das Bauteil auf seinem Flugkreis von einer mittleren Kamera frontal erfasst wird und von den zu beiden Seiten der mittleren Kamera befindlichen Kameras jeweils einander gegenüberliegende Mantelflächen erfasst werden. Diese Kameras sind nicht zwingend Farbkameras. Vielmehr können auch Schwarz/Weiß-Kameras eingesetzt sein. An dieser Position wird das Bauteil sowohl auf Fehler hin untersucht, als auch werden die Bilddaten auf Positionsdaten hin ausgewertet. Mit der Seiteninspektion durch die beiden seitlichen Kameras wird das Bauteil an seinen Schnittflächen auf Beschädigungen untersucht. Mit der Rückseiteninspektion durch die mittlere Kamera wird die Bauteilrückseite auf Beschädigungen untersucht. Für die Rückseiteninspektion können mehrere Bildeinzüge durchgeführt werden um verschiedene Defekte hervorzuheben. Für die nachfolgende Ablage des Bauteils in der Empfangseinrichtung können die Positionsdaten (x, y, Verdrehung) des Bauteils mit der Seiteninspektion ermittelt werden. In einer anderen Variante wird hierfür die Rückseiteninspektion verwendet. Diese Informationen werden von der Steuerung verwendet um etwaige Korrekturen durchzuführen. Bei den hier verwendeten Kameras kann es sich ebenfalls um Farbkameras handeln. Dies ist jedoch nicht zwingend erforderlich, da während des Stillstandszeitraums ausreichend Zeit zur Verfügung steht.

Die hier offenbarte integrierte Handhabungs-/Inspektionseinrichtung verwendet des Weiteren bildgebende Sensoren in Form einer Kamera im Zentrum der unteren Wendeeinrichtung. Diese Kamera kann eine Farbkamera mit drei einzelnen Kanälen R, G, B sein. Dabei ist es unerheblich, ob eine 3-Chip Farbkamera oder eine 1-Chip Farbkamera eingesetzt wird. 3-Chip Kameras haben für jede Farbe R, G, B einen separaten Bildsensor, eine 1-Chip Kamera verwendet alternierend aktivierte Filter vor dem Bildsensor. Eine hier einsetzbare Schwarz/Weiß-Kamera hat einen Kanal mit zum Beispiel 255 Grau-Stufen, bei einer Farbkamera hat jeder der drei Kanäle zum Beispiel 255 Intensitäts-Stufen einer Farbe. Wesentlich ist, dass die drei Farbkanäle der Kamera getrennt voneinander ansprechbar/auszulesen sind, oder zumindest eine Aufspaltung der drei Farbkanäle in der Steuerung erfolgen kann. Für jeden Kanal sind unterschiedliche Belichtungszeiten möglich. Hier können zum Beispiel folgende Belichtungszeiten verwendet werden: 5 ms (grün), 12 ms (rot), 15 ms (blau). Entsprechend der jeweils aktivierten Farbkanäle werden bei der hier offenbarten integrierte Handhabungs-/Inspektionseinrichtung auch unterschiedliche Beleuchtungsfarben verwendet. Weißes Licht ist zwar eine Mischung aus allen Farben, so dass mit dieser Beleuchtungsfarbe alle Kanäle gleichzeitig angesprochen werden könnten. Dies findet hier jedoch dezidiert nicht statt, wenn die erzielbare Bildqualität den Anforderungen nicht entspricht.

Dem bildgebenden Sensor ist in einer Variante ein halbdurchlässiger Spiegel zugeordnet, der unter einem Winkel von etwa 45° zur optischen Achse des Kamera-Chips angeordnet ist und dazu dient, farbiges Licht zweier, mehrerer oder beliebig vieler unterschiedlicher Erfassungsspektren aus entsprechenden Lichtquellen optisch einzukoppeln und auf einen Inspektionsbereich zu richten. Dieses auf den Inspektionsbereich, also die Bauteil-Deckfläche oder Seitenfläche und ggf. deren Umgebung in der Tasche, gerichtete Licht wird dort reflektiert und wird von wenigstens einem Kamera-Chip des bildgebenden Sensors erfasst.

Weiterhin ist in einer Variante dem bildgebenden Sensor eine Lichtquelle als Ringlichtquelle um die Inspektionsstelle zugeordnet. Diese Ringlichtquelle liefert Streulicht unter einem Winkel von etwa 5° - 45° in einem dritten Farbbereich. Auch dieses auf den Inspektionsbereich gerichtete Licht wird dort reflektiert und wird von wenigstens einem Kamera-Chip des bildgebenden Sensors erfasst. Das Licht bzw. die verschiedenfarbigen Lichtquellen können beliebig angeordnet sein bzw. auch den gleichen Strahlungswinkel haben.

Die hier offenbarte integrierte Handhabungs-/Inspektionseinrichtung verwendet im Zentrum der unteren Wendeeinrichtung einen Umlenkspiegel zur Einkopplung einer koaxialen Beleuchtung der Empfangseinrichtung. Genauer wird der durch die Empfangseinrichtung geführte Träger in Form eines Ablagebandes mit Ablagetaschen für die Bauteile mit der Kamera erfasst. Durch eine einzige Bildaufnahme erfolgt eine Inspektion auf Fehler, zum Beispiel das schräge Ablegen des Bauteils, so dass es nicht korrekt in seiner Ablagetasche positioniert ist, oder auf Qualitätsmängel. Außerdem werden durch diese einzige Bildaufnahme die Positionsdaten der Ablagetasche des Ablagebandes für das Ablegen des nächsten Bauteils erfasst. Die aus den einzelnen Farbkanälen zu gewinnende Information kann nach zu untersuchenden Aufgabenstellungen beliebig aufgeteilt werden, beispielsweise wie folgt: Bildkanal 1 mit Beleuchtungstyp 1: Position der Ablagetasche des Ablagebandes zur Positionierung des nächsten Bauteils. Bildkanal 2 mit Beleuchtungstyp 2: Qualitätsinspektion des Bauteils (Risse, Lasermarken, Ausbrüche, ...). Bildkanal 3 mit Beleuchtungstyp 3: Zusatzinspektionen für spezielle Bauteile oder kundenspezifische Fehler.

Das Bauteil wird bei einer Variante der integrierten Handhabungs-/Inspektionseinrichtung "blind" abgelegt. Das heißt, dass der eigentliche Ablegevorgang auf Informationen oder Positionsdaten basiert, die vor dem Ablegevorgang aus der Bildaufnahme gewonnen wurde, die dem vorherigen Bauteil zugeordnet ist. Im Moment des Ablegevorgangs sieht die Kamera im Zentrum der zweiten Wendeeinrichtung die Ablegestelle nicht, da der momentan ablegende Aufnehmer die Sicht versperrt.

Informationen oder Positionsdaten, ob ein Bauteil verdreht ist, liefert in einer Variante eine Kamera am Außenumfang der unteren Wendeeinrichtung. Die Informationen oder Positionsdaten werden an die Steuerung der Empfangseinrichtung weitergegeben. Aus der Bildaufnahme des zuvor in der Ablagetasche des Ablagebandes abgelegten Bauteils ist die Position der Empfangseinrichtung bekannt. Der Abstand zwischen den beiden Taschen ist ebenso bekannt. Hieraus kann für das nächste abzulegende Bauteil errechnet werden, um welchen Winkel und x- und y-Betrag die Empfangseinrichtung bewegt werden muss.

Aus den weiteren Vorrichtungsaspekten ergeben sich entsprechende ergänzende oder alternative Verfahrensschritte.

Die hier vorgestellte Anordnung bildgebender Sensorik ist in der Lage, mit weniger Bildeinzügen als herkömmliche Sensoranordnungen auszukommen. Die gewonnenen Bilddaten lassen sich sowohl zur Schlechtteilausschleusung als auch zur Positionierung der Aktoren der Handhabungs-/Inspektionseinrichtung auswerten. Diese integrierte Architektur und die sich damit ermöglichende Vorgehensweise reduziert die Prozesszeit und bietet bei erhöhter Durchsatzzahl eine gesteigerte Inspektionsqualität.

### Kurzbeschreibung der Figuren

Weitere Merkmale, Eigenschaften, Vorteile und mögliche Abwandlungen werden für einen Fachmann anhand der nachstehenden Beschreibung deutlich, in der auf die beigefügten Zeichnungen Bezug genommen ist. Dabei zeigen die Fig. schematisch eine optische Untersuchungseinrichtung für ein Bauteil,
Fig. 1 zeigt schematisch eine Bauteilhandhabungsvorrichtung zum Entnehmen von prismatischen oder zylindrischen Bauteilen von einem strukturierten Bauteilvorrat und zum Ablegen an einer Empfangseinrichtung in einer Seitenansicht.
Fig. 2 zeigt schematisch die Ausrichtung der diversen Lage- und Eigenschaftssensoren der Bauteilhandhabungsvorrichtung aus Fig. 1 in Bezug auf die Seitenflächen eines Bauteils.
Fig. 3 zeigt schematisch einen der am Umfang einer oder beider Wendeeinrichtungen der Bauteilhandhabungsvorrichtung angeordneten Lage- und Eigenschaftssensoren in einer Draufsicht.
Fig. 4 zeigt schematisch eine Empfangseinrichtung zum Einsatz mit der Bauteilhandhabungsvorrichtung in einer perspektivischen Ansicht.
Fig. 5 zeigt schematisch einen der Lage- und Eigenschaftssensoren mit zugeordneter Beleuchtungsanordnung zum Einsatz mit der Bauteilhandhabungsvorrichtung.

### Detaillierte Beschreibung der Figuren

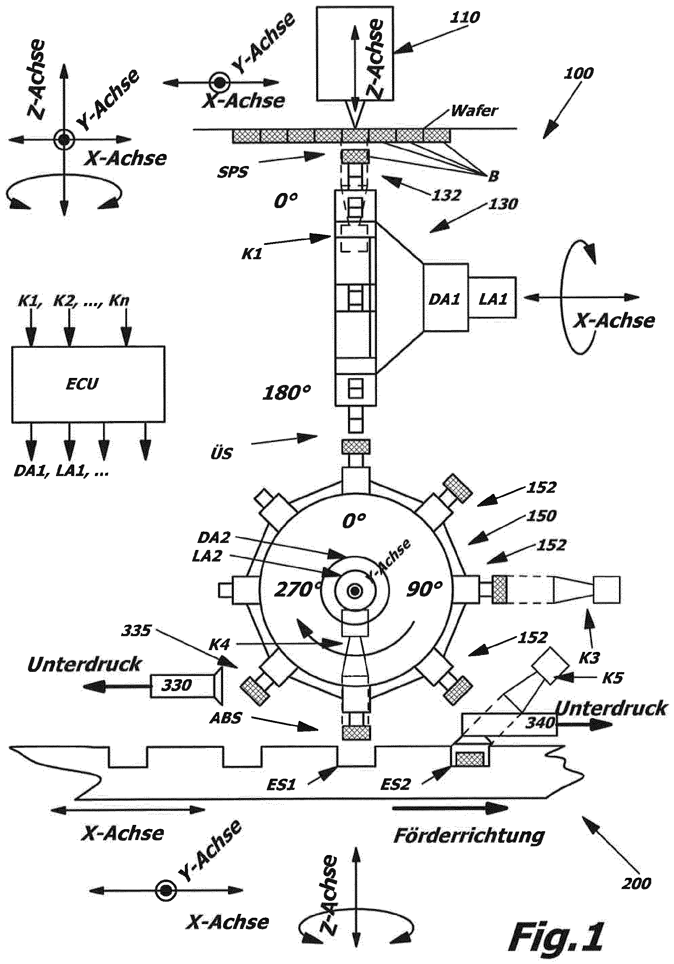

In Fig. 1 ist eine Bauteilhandhabungsvorrichtung 100 zum Entnehmen von prismatischen Bauteilen B in Form elektronischer Halbleiterchips von einem strukturierten Bauteilvorrat und zum Ablegen an einer Empfangseinrichtung 200 veranschaulicht. Die hier vorgestellte Bauteilhandhabungsvorrichtung 100 übernimmt die Bauteile B von einem horizontal im oberen Bereich der Bauteilhandhabungsvorrichtung angeordneten Bauteilvorrat, hier einer Waferscheibe, mit einer ortsfesten Ausstoßeinheit 110.

Die Ausstoßeinheit 110 arbeitet in der gezeigten Variante mit einer durch eine Steuerung ECU kontrollierten Nadel oder sie arbeitet zum Beispiel berührungslos mit einem Laserstrahl, um die Bauteile einzeln von dem Bauteilvorrat freizugeben, damit sie einer ersten Wendeeinrichtung 130 zugeführt werden. Diese erste Wendeeinrichtung 130 hat die Form eines Sterns oder Rades und hat an ihrem Umfang mehrere (im gezeigten Beispiel acht) Aufnehmer 132 für die vereinzelten Bauteile B. Jeder der Aufnehmer 132 ist dazu eingerichtet, wenn er sich bei der 0°-Position der ersten Wendeeinrichtung 130 der Ausstoßeinheit 110 am nächsten befindet, an einer Spendestelle SPS ein Bauteil von dem strukturierten Bauteilvorrat zu empfangen.

Die Aufnehmer 132 sind radial nach außen weisend am (gedachten) Umfang der stern- oder radförmigen ersten Wendeeinrichtung 130 angeordnet und tragen die Bauteile B. Die Aufnehmer 132 der ersten Wendeeinrichtung 130 sind zur Drehachse (hier der X-Achse) radial verfahrbar. Somit können diese Aufnehmer 132 die Bauteile B, jeweils an einem der Aufnehmer 132 fixiert, innerhalb eines Schwenkwinkels - hier zwischen 0° und 180° - zwischen Bauteil-Übernahme und -Übergabe fördern.

Die erste Wendeeinrichtung 130 rotiert das Bauteil B, gesteuert von der nicht weiter veranschaulichten Steuerung ECU um eine erste Achse, hier die X-Achse, zu einer ersten Übergabestelle ÜS um einen ersten vorbestimmten Winkel, hier 180°. Dabei wird das Bauteil B um seine Längs- oder Querachse gewendet. Eine der ersten Wendeeinrichtung 130 ähnliche zweite Wendeeinrichtung 150 mit mehreren, hier ebenfalls acht, zweiten Aufnehmern 152 ist dazu eingerichtet, das Bauteil B an der Übergabestelle ÜS von einem Aufnehmer 132 der ersten Wendeeinrichtung 130 zu empfangen, wenn das Bauteil sich bei der 0°-Position der zweiten Wendeeinrichtung 130 der Übergabestelle ÜS am nächsten befindet.

Die zweite Wendeeinrichtung 150 wendet das empfangene Bauteil B, gesteuert von der Steuerung ECU, um eine zweite Achse, hier die Y-Achse, um einen zweiten vorbestimmten Winkel, hier um etwa 180°, um seine Längs- oder Querachse und fördert es zu einer Ablagestelle ABS.

Die ersten, zweiten und/oder dritten Achsen schließen miteinander jeweils einen Winkel von 90° plus/minus maximal 10° oder 15° ein und orientieren sich an einem dreidimensionalen orthogonalen Koordinatensystem.

Die beiden stern- oder radförmigen Wendeeinrichtungen 130, 150 sind orthogonal zueinander angeordnet und stimmen ansonsten in ihrem Aufbau überein. Abweichend von der Darstellung in Fig. 1 kann die Anordnung der beiden Wendeeinrichtungen 130, 150 relativ zur Förderrichtung der Empfangseinrichtung 200 auch um die Z-Achse um 90° gedreht sein. In diesem Fall ist die untere Wendeeinrichtung 150 zumindest annähernd quer zur Förderrichtung der Empfangseinrichtung 200 orientiert.

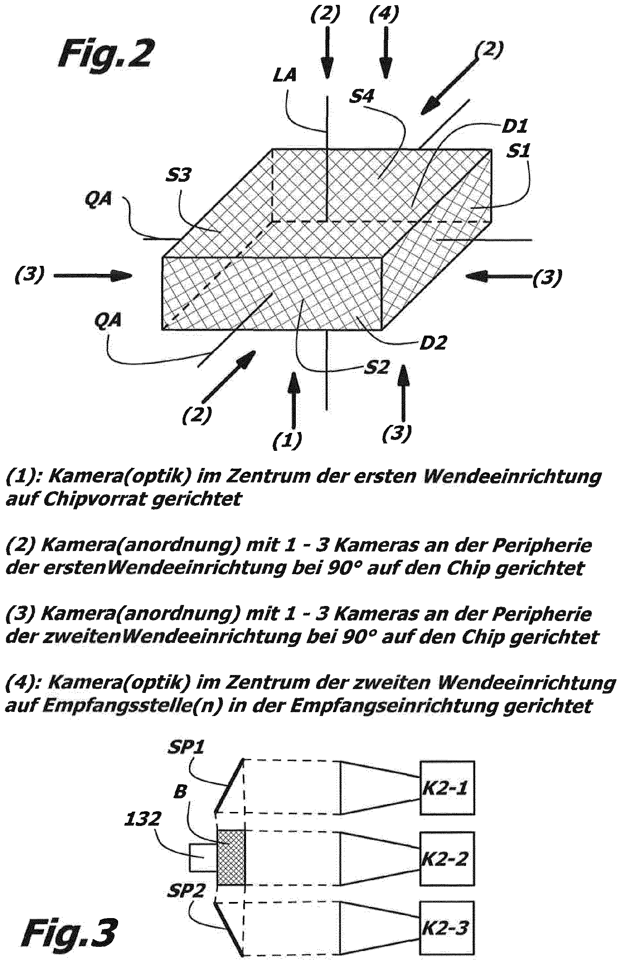

Den ersten und zweiten Wendeeinrichtungen 130, 150 sind Lage- und Eigenschaftssensoren K1 ... K4 zugeordnet. Wie in Fig. 1 gezeigt, befinden sich diese Sensoren an mehreren Stellen der Gesamtanordnung. Sie sind dazu eingerichtet, Lagedaten der ersten und zweiten Wendeeinrichtungen 130, 150, Lagedaten von an den Aufnehmern 132, 152 befindlichen Bauteilen B, sowie Eigenschaften von an den Aufnehmern 132, 152 befindlichen Bauteilen B zu erfassen. Die dabei gewonnenen Daten werden einer Steuerung zur Verfügung gestellt. In der hier veranschaulichten Ausführung ist eine erste Kameraanordnung K1 im Zentrum der ersten Wendeeinrichtung 130 senkrecht nach oben auf den Bauteilvorrat gerichtet. Eine zweite Kameraanordnung K2 mit drei Kameras - in Fig. 1 nicht zu sehen - ist an der Peripherie der ersten Wendeeinrichtung 130 bei 90° auf das daran vorbeigeführte Bauteil B gerichtet. Details zu dieser zweiten Kameraanordnung K2 werden im Zusammenhang mit Fig. 3 erläutert. Eine der zweiten Kameraanordnung K2 entsprechende dritte Kameraanordnung K3 mit drei Kameras ist an der Peripherie der zweiten Wendeeinrichtung 150 bei 90° auf das daran vorbeigeführte Bauteil B gerichtet. Eine vierte Kameraanordnung K4 ist im Zentrum der zweiten Wendeeinrichtung 150 auf die Ablagestelle ABS oder die erste Empfangsstelle ES1 in der Empfangseinrichtung 200 gerichtet.

Die Steuerung ECU ist dazu eingerichtet, mittels eines ersten Drehantriebes DA1 die erste Wendeeinrichtung 130 um eine erste Achse (hier die X-Achse) kontrolliert zu drehen und mittels eines ersten Linearantriebes LA1 die erste Wendeeinrichtung 130 längs der ersten Achse kontrolliert zu verfahren.

Die Steuerung ECU ist weiterhin dazu eingerichtet, mittels eines zweiten Drehantriebes DA2 die zweite Wendeeinrichtung 150 um eine zu der ersten Achse (hier die X-Achse) nicht kollineare zweite Achse (hier die Y-Achse) kontrolliert zu drehen, und mittels eines zweiten Linearantriebes LA2 die zweite Wendeeinrichtung 150 längs der zweiten Achse kontrolliert zu verfahren.

Die bildgebenden Sensoren inspizieren die Deck- und/oder Seitenfläche(n) des Bauteils B und liefern dabei auch relevante Daten zur Positionierung der ersten und zweiten Wendeeinrichtungen 130, 150 längs und um deren Achsen, sowie der Aufnehmer 132, 152 und der an ihnen befindlichen Bauteile B und der Empfangsstellen.

Die Bauteilhandhabungsvorrichtung 100 ist mit einer der Ablagestelle ABS zugeordneten Empfangseinrichtung 200 für ein dorthin gefördertes Bauteil B ausgestattet. Der Empfangseinrichtung 200 sind dabei Lage- und Eigenschaftssensoren K4, K5 zugeordnet, die dazu eingerichtet sind, Lagedaten des an die Ablagestelle ABS geförderten Bauteils B, Lagedaten und Eigenschaften von Empfangsstellen ES1, ES2 in der Empfangseinrichtung 200 und der darin befindlichen Bauteile B zu erfassen und für eine Steuerung ECU zur Verfügung zu stellen. Dabei ist der Lage- und Eigenschaftssensor K5 eine fünfte Kameraanordnung, die auf ein zweites Fenster an der zweiten Empfangsstelle ES2 gerichtet ist. Die Steuerung ECU ist dazu eingerichtet, mittels eines dritten Drehantriebes DA3 die Empfangseinrichtung 200 um eine die Ablagestelle ABS enthaltende dritte Achse (hier die Z-Achse) kontrolliert zu drehen und mittels eines dritten und eines vierten Linearantriebes LA3, LA4 die Empfangseinrichtung längs der ersten und der zweiten Achsen kontrolliert zu verfahren. Mittels eines vierten Drehantriebes DA4 verfährt die Steuerung ECU einen durch die Empfangseinrichtung 200 geführten Träger 320 längs der ersten Achse (hier die X-Achse) kontrolliert. Dieser Träger 320 dient dazu, die Bauteile B in vereinzelter Form von der zweiten Wendeeinrichtung 150 aufzunehmen. Die Wendeeinrichtungen 130, 150 und die Drehantriebe DA1, DA2, ... haben jeweils einen mit der Steuerung ECU verbundenen, nicht weiter dargestellten hochauflösenden rotatorischen Winkel-Encoder zur Bestimmung ihrer jeweiligen Rotationsstellung.

In der Empfangseinrichtung 200 dient der vierte Drehantrieb DA4 dazu, durch Steuersignale aus der Steuerung ECU angesteuert, den durch die Empfangseinrichtung 200 geführten Träger 320 längs der ersten Achse (hier der X-Achse) kontrolliert um etwa 100% plus minus maximal 3% des Rastermaßes benachbarter Bauteil-Aufnahmen (Taschen) des Trägers 320 zu verfahren. Das Rastermaß ergibt sich aus dem Mittenabstand zweier aufeinander folgender Taschen. Der dritte Drehantrieb DA3 ist dazu eingerichtet, durch Steuersignale aus der Steuerung ECU angesteuert, in Abhängigkeit von Signalen aus dem bildgebenden Eigenschafts- und Lagesensor im Zentrum der zweiten Wendeeinrichtung 150 eine der Empfangsstellen E1 mit der dort befindlichen Bauteil-Aufnahme des Trägers 320 um die die Ablagestelle enthaltende Z-Achse kontrolliert um bis zu plus minus 6 ° zu drehen.

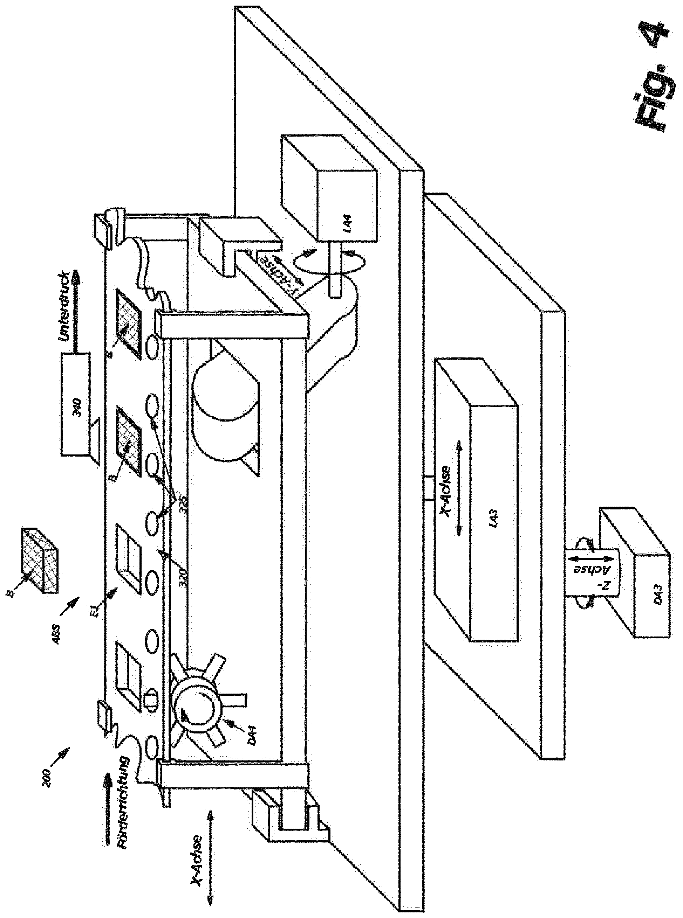

Der vierte Drehantrieb DA4 der Empfangseinrichtung 200 hat in der in Fig. 4 gezeigten Varianten ein Stachelrad, das in Transportlöcher 325 des Trägers 320 (Ablagebandes) eingreift um es in Förderrichtung zu transportieren. Das Stachelrad dreht dabei bevorzugt nur in eine Vorwärts-Richtung.

Bei der Empfangseinrichtung 200 ist in dieser Variante eine Absaug- und/oder Ausblaseinrichtung 340 abstromseitig zur Empfangsstelle ES1 vorgesehen. Diese ist jedoch optional. Damit werden, durch Steuersignale aus der Steuerung ECU angesteuert, als schadhaft oder fehlerhaft platziert erkannte Bauteile aus ihrer Tasche entfernt.

Zum Ansaugen des Bauteils B in den Aufnehmern 132, 152, zum Halten des Bauteils B in den Aufnehmern 132, 152, zum Ablegen des Bauteils B mit oder ohne gesteuertem Abblas-Impuls, und zum freien Abblasen des Bauteils B aus den Aufnehmern 132, 152 sind diese mit einer nicht weiter veranschaulichten Pneumatikeinheit verbunden. Die Pneumatikeinheit beaufschlagt, von der Steuerung ECU kontrolliert, die einzelnen Aufnehmer 132, 152 ventilgesteuert zum jeweils erforderlichen Zeitpunkt oder Zeitraum mit Über- oder Unterdruck um die Bauteile einzeln aufzunehmen, zu halten und wieder abzugeben.

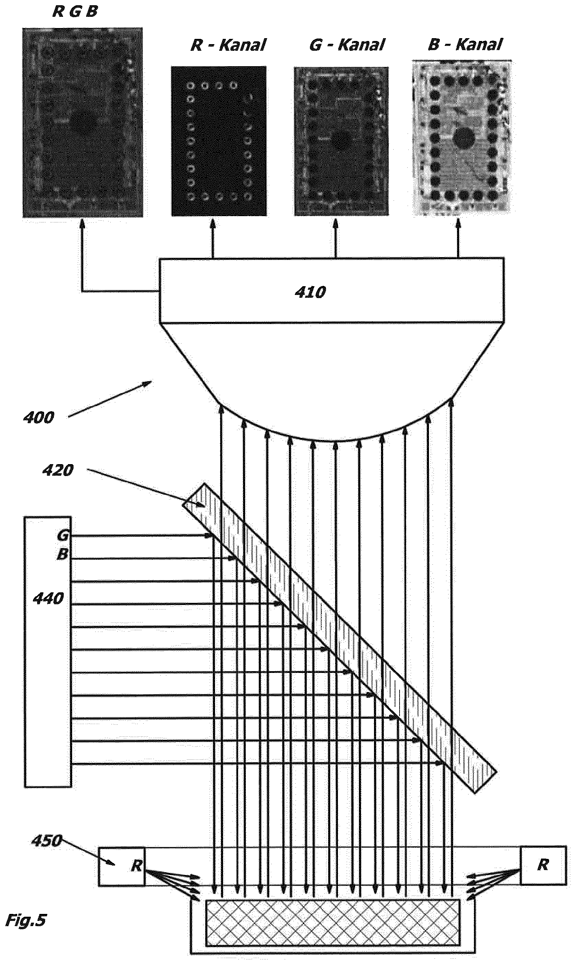

Sofern die mittels der Steuerung ECU und den Lage- und Eigenschaftssensoren an den einzelnen Stationen gewonnenen Inspektionsergebnisse positiv sind, wird das jeweilige Bauteil B in die momentan an der Ablegestelle ABS befindliche Empfangsstelle ES1, also die Tasche des Trägers 320 abgelegt. Sofern die gewonnenen Inspektionsergebnisse negativ sind, wird das Bauteil B um eine weitere Position zu einem ersten Absauger 330 weiter rotiert, wo es von seinem Aufnehmer 152 an der zweiten Wendeeinrichtung 150 abgesogen wird. Sofern sich durch einen diese Empfangsstelle ES1 überwachenden Lage- und Eigenschaftssensor (siehe auch Fig. 5) ergibt, dass das abgelegte Bauteil B nach der Ablage einen Lage- oder Eigenschaftsfehler hat, wird es mittels eines abstromseitig zur Empfangsstelle ES1 befindlichen zweiten Absaugers 340 aus der Tasche des Trägers 320 herausgesaugt. Anschließend wird in diesem Fall, von der Steuerung ECU kontrolliert, die gesamte Empfangseinrichtung 200 zusammen mit dem Träger 320 um den Mittenabstand zweier Taschen des Trägers 320 mit der dritten Linearantriebseinheit LA3 entgegen der Förderrichtung des Trägers 320 zurückgesetzt. Dann wird das nächste Bauteil B an der zweiten Wendeeinrichtung 150 in die freigewordene Tasche des Trägers 320 eingebracht.

Bei einer weiteren Variante ist der ersten Empfangsstelle ES1 eine zusätzliche, nicht weiter veranschaulichte Absaugeinrichtung zugeordnet, um ein schräg liegendes Bauteil an der Empfangsstelle ES1 abzusaugen. Durch den Lage- und Eigenschaftssensor K4 oder durch den Lage- und Eigenschaftssensor K5 am zweiten Fenster können etwaige Qualitätsfehler festgestellt werden. Sofern der Lage- und Eigenschaftssensor K5 einen Qualitätsfehler erfasst, wird die Empfangseinrichtung 200 zusammen mit dem Träger 320 zurücktransportiert, an der Ablagestelle wird dann das Bauteil B aus der Tasche des Trägers 320 abgesaugt. Eine Verkippung eines schräg liegenden Bauteils an der Empfangsstelle ES1 kann durch einen nicht weiter dargestellten Lage- und Eigenschaftssensor K6 erkannt werden, welcher der Empfangsstelle ES1 zugeordnet ist. Dieser Lage- und Eigenschaftssensor K6 ist seitlich zum Träger 320 angeordnet und erfasst die Empfangsstelle ES1 direkt oder über einen Umlenkspiegel über die Oberkante des Trägers 320. So kann eine etwaige Verkippung oder ein Überstand eines nicht korrekt abgelegten Bauteils erkannt werden.

Wie in der Fig. 2 in Verbindung mit der Fig. 1 veranschaulicht ist, ist die Kameraanordnung K1 als Lage- und Eigenschaftssensor im Zentrum der ersten Wendeeinrichtung 130 auf den Bauteilvorrat gerichtet. Damit wird die Deckfläche D2 des Bauteils B auf Lage und Fehler inspiziert. Dabei ist die Kameraanordnung K1 dazu eingerichtet, einen Bildeinzug jeweils während der Wendebewegung der ersten Wendeeinrichtung 130 zwischen zwei benachbarten Aufnehmern 132 hindurch auszuführen. Die Steuerung erzeugt aus diesen Bilddaten entsprechende Korrekturbewegungen der Ausstoßeinheit, des Bauteilvorrats bzw. des Wafers und der ersten Wendeeinrichtung 130.

Die zweite Kameraanordnung K2 ist als Lage- und Eigenschaftssensor mit ihren drei Kameras an der Peripherie der ersten Wendeeinrichtung 130 bei etwa 90° auf die drei Seiten S2, S4 und D1 des Bauteils B gerichtet. Eine Draufsicht auf die Kameraanordnung K2 mit ihren drei Kameras K2-1, K2-2 und K2-3 ist in Fig. 3 veranschaulicht. Hierbei inspiziert die mittlere Kamera K2-2 die Deckfläche D1 des Bauteils B und die beiden äußeren Kamera K2-1 und K2-3 über jeweilige Spiegel SP1 und SP2 die Seitenflächen S2 und S4 des Bauteils B. Aus den dabei erfassten Bildeinzügen lässt sich neben etwaigen Fehlern des Bauteils B an diesen Flächen auch die genaue Lage und Rotation des Bauteils B an seinem Aufnehmer 132 bestimmen. Diese Information wird in der Steuerung ECU dazu verwendet, die Ausrichtung der ersten Wendeeinrichtung 130 sowie der zweiten Wendeeinrichtung 150 längs ihrer Achsen und Rotationsorientierung zu verändern, wenn das inspizierte Bauteil B an der Übergabestelle ÜS von der ersten Wendeeinrichtung 130 zu der zweiten Wendeeinrichtung 150 übergeben wird.

Die dritte Kameraanordnung K3 ist als Lage- und Eigenschaftssensor mit ihren drei Kameras extern an der Peripherie der zweiten Wendeeinrichtung 150 bei etwa 90° auf die drei Seiten S1, S3 und D2 des Bauteils B gerichtet. Diese Kameraanordnung K3 entspricht in ihrem Aufbau und ihrer Anordnung der Kameraanordnung K2 mit ihren drei Kameras und beiden Spiegeln in Fig. 3. Aus den dabei erfassten Bildeinzügen lässt sich neben etwaigen Fehlern des Bauteils B an diesen Flächen auch die genaue Lage und Rotation des Bauteils B an seinem Aufnehmer 152 der zweiten Wendeeinrichtung 150 bestimmen. Diese Information wird in der Steuerung ECU dazu verwendet, die Ausrichtung der zweiten Wendeeinrichtung 150 sowie der Empfangseinrichtung 200 längs ihrer Achsen und Rotationsorientierungen zu verändern, wenn das inspizierte Bauteil B an der Übergabestelle ÜS von der zweiten Wendeeinrichtung 150 in die an der Ablegestelle ABS befindliche Empfangsstelle ES1, also die Tasche des Trägers 320 abgelegt wird.

Die vierte Kameraanordnung K4 ist als Lage- und Eigenschaftssensor im Zentrum der zweiten Wendeeinrichtung 150 auf die Empfangsstelle E1 in der Empfangseinrichtung 200 gerichtet. Auch diese Kameraanordnung K4 ist dazu eingerichtet, einen Bildeinzug jeweils während der Wendebewegung der zweiten Wendeeinrichtung 150 zwischen zwei benachbarten Aufnehmern hindurch auszuführen. Die Steuerung ECU veranlasst dann entsprechende Korrekturbewegungen der zweiten Wendeeinrichtung 150 und der Empfangseinrichtung 200.

Der in Fig. 5 veranschaulichte Lage- und Eigenschaftssensor 400 ist als bildgebender Sensor eine Variante der Kameraanordnungen K1 - K5. Dieser Sensor 400 hat einen das sichtbare Lichtspektrum aufnehmenden Kamera-Chip 410. Bei diesem bildgebenden Sensor 400 sind die drei voneinander abweichenden Erfassungsspektren als roter Farbbereich - 630nm plus minus 30 nm -, als grüner Farbbereich - 530 nm plus minus 60 nm -, und als blauer Farbbereich - 460nm plus minus 50 nm - eines Farbsensors ausgestaltet.

Dem bildgebenden Sensor 400 ist ein halbdurchlässiger Spiegel 420 zugeordnet, der unter einem Winkel von etwa 45° zur optischen Achse des Kamera-Chips 410 angeordnet ist. Der halbdurchlässige Spiegel 420 dient dazu, farbiges Licht zweier Erfassungsspektren, hier dem grünen Farbbereich und dem blauen Farbbereich, aus entsprechenden Lichtquellen 440 optisch einzukoppeln und auf eine Deckfläche des Bauteils B zu richten. Dieses auf das Bauteil B gerichtete Licht im grünen und im blauen Farbbereich erfasst der Kamera-Chip 410. Je nach räumlichen Gegebenheiten können auch andere Umlenkspiegel, Prismen, Farbfilter oder Linsen vorgesehen sein.

Eine weitere Lichtquelle 450 ist in einer Ausgestaltung als Ringlichtquelle um die an der Ablegestelle ABS befindliche Empfangsstelle ES1 angeordnet und liefert Streulicht unter einem Winkel von etwa 5° - 45° im roten Farbbereich auf die Deckfläche des Bauteils B. Auch dieses auf das Bauteil B gerichtete Licht im roten Farbbereich erfasst der Kamera-Chip 410.

Einzelne der optisch wirksamen Elemente und/oder der Strahlungsquellen können dazu eingerichtet sein, unabhängig von anderen ausgerichtet und/oder justiert / fokussiert zu werden.

Der Kamera-Chip 410 ist in der vorliegenden Variante eine Farbkamera mit drei einzelnen Kanälen R, G, B. Es kann aber auch eine Kamera mit mehreren Kanälen sein. Die drei Farbkanäle der Kamera sind getrennt voneinander ansprechbar/ auszulesen. Mit einer einzigen Bildaufnahme wird das Bauteil B auf Fehler inspiziert, zum Beispiel das schräge Ablegen des Bauteils B, so dass es nicht korrekt in der vorgesehenen Tasche des Trägers 320 positioniert ist, oder auf Qualitätsmängel. Außerdem werden durch diese einzige Bildaufnahme die exakten Positionsdaten der Tasche des Trägers 320 für das Ablegen des nächsten Bauteils B erfasst. Die aus den einzelnen Farbkanälen zu gewinnende Information teilt sich wie folgt auf: Bildkanal 1 mit Beleuchtungstyp 1: Position der Ablagetasche des Ablagebandes zur Positionierung des nächsten Bauteils. Bildkanal 2 mit Beleuchtungstyp 2: Qualitätsinspektion des Bauteils (Risse, Lasermarken, Ausbrüche, ...). Bildkanal 3 mit Beleuchtungstyp 3: Zusatzinspektionen für spezielle Bauteile oder kundenspezifische Fehler.

Durch die hier vorgestellte bildgebende Sensorik sind weniger Bildeinzüge erforderlich als mit herkömmlichen Sensoranordnungen um eine Schlechtteilausschleusung und eine Positionierung der Aktoren zu realisieren.

Es sei bemerkt, dass obwohl hier numerische Bereiche und numerische Werte offenbart wurden, alle numerischen Werte zwischen den offenbarten Werten und jedem numerischen Unterbereich innerhalb der genannten Bereiche als ebenfalls offenbart anzusehen sind.

Die vorangehend beschriebenen Varianten der Vorrichtung sowie deren Aufbau- und Betriebsaspekte dienen lediglich dem besseren Verständnis der Struktur, der Funktionsweise und der Eigenschaften; sie schränken die Offenbarung nicht etwa auf die Ausführungsbeispiele ein. Die Fig. sind teilweise schematisch, wobei wesentliche Eigenschaften und Effekte zum Teil deutlich vergrößert dargestellt sind, um die Funktionen, Wirkprinzipien, technischen Ausgestaltungen und Merkmale zu verdeutlichen. Dabei kann jede Funktionsweise, jedes Prinzip, jede technische Ausgestaltung und jedes Merkmal, welches/welche in den Fig. oder im Text offenbart ist/sind, mit allen Ansprüchen, jedem Merkmal im Text und in den anderen Fig., anderen Funktionsweisen, Prinzipien, technischen Ausgestaltungen und Merkmalen, die in dieser Offenbarung enthalten sind oder sich daraus ergeben, frei und beliebig kombiniert werden, so dass alle denkbaren Kombinationen der beschriebenen Vorgehensweise zuzuordnen sind. Dabei sind auch Kombinationen zwischen allen einzelnen Ausführungen im Text, das heißt in jedem Abschnitt der Beschreibung, in den Ansprüchen und auch Kombinationen zwischen verschiedenen Varianten im Text, in den Ansprüchen und in den Fig. umfasst. Auch die Ansprüche limitieren nicht die Offenbarung und damit die Kombinationsmöglichkeiten aller aufgezeigten Merkmale untereinander. Alle offenbarten Merkmale sind explizit auch einzeln und in Kombination mit allen anderen Merkmalen hier offenbart.

### Bezugszeichen

Ablagestelle **ABS**
Bauteil **B**
Seitenflächen **S1, S2, S3, S4** des Bauteils
Deckflächen **D1, D2** des Bauteils
erster Drehantrieb **DA1** zum Drehen der ersten Wendeeinrichtung um erste Achse (X-Achse)
zweiter Drehantrieb **DA2** zum Drehen der zweiten Wendeeinrichtung um zweite Achse (Y-Achse)
dritter Drehantrieb **DA3** zum Drehen der Empfangseinrichtung um eine die Ablagestelle ABS enthaltende dritte Achse (Z-Achse)
vierter Drehantrieb **DA4** der Empfangseinrichtung transportiert den Träger in Förderrichtung
erster Linearantrieb **LA1** zum Verfahren der ersten Wendeeinrichtung längs erster Achse (X-Achse)
zweiter Linearantrieb **LA2** zum Verfahren der zweiten Wendeeinrichtung längs zweiter Achse (Y-Achse)
dritter Linearantrieb **LA3** zum Verfahren der Empfangseinrichtung längs erster Achse vierter Linearantrieb **LA4** zum Verfahren der Empfangseinrichtung längs zweiter Achse
fünfter Linearantriebes **LA5** zum Verfahren eines durch die Empfangseinrichtung geführten Trägers längs erster Achse (X-Achse)
erste Empfangsstelle **ES1**
zweite Empfangsstelle **ES2**
Steuerung **ECU**
Lage- und Eigenschaftssensoren **K1** ... **K4, K5**
erste Kameraanordnung **K1** im Zentrum der ersten Wendeeinrichtung senkrecht nach oben gerichtet
zweite Kameraanordnung **K2** mit drei Kameras ist an der Peripherie der ersten Wendeeinrichtung bei 90° auf das daran vorbeigeführte Bauteil gerichtet
dritte Kameraanordnung **K3** mit drei Kameras ist an der Peripherie der zweiten Wendeeinrichtung bei 90° auf das daran vorbeigeführte Bauteil gerichtet
vierte Kameraanordnung **K4** ist im Zentrum der zweiten Wendeeinrichtung auf die Ablagestelle oder die erste Empfangsstelle in der Empfangseinrichtung gerichtet fünfte Kameraanordnung **K5** ist auf zweites Fenster an der zweiten Empfangsstelle gerichtet
Spiegel **SP1, SP2**
Spendestelle **SPS**
Übergabestelle **ÜS**
Bauteilhandhabungsvorrichtung **100**
Ausstoßeinheit **110**
erste Wendeeinrichtung **130**
erste Aufnehmer **132**
zweite Wendeeinrichtung **150**
zweite Aufnehmer **152**
Empfangseinrichtung **200**
Träger **320**
Transportlöcher **325**
erster Absauger **330**
Ausschleusstelle **335**
Absaug- und/oder Ausblaseinrichtung **340**
Sensor **400**
Kamera-Chip **410**
halbdurchlässiger Spiegel **420**
Lichtquellen **440**
weitere Lichtquelle **450**

## Patentansprüche

1. Empfangseinrichtung (200) für Bauteile (B), die dazu eingerichtet ist, relativ zu einer Ablagestelle (ABS) mittels
- eines Drehantriebes (DA3) zumindest teilweise um eine die Ablagestelle (ABS) enthaltende dritte Achse (Z-Achse) kontrolliert zu drehen, mittels
- wenigstens eines Linearantriebes (LA4) zumindest teilweise längs einer der ersten, zweiten und/oder dritten Achsen (X-, Y-, Z-Achse) kontrolliert zu verfahren, und mittels
- eines Drehantriebes (DA4) einen durch die Empfangseinrichtung (200) geführten Träger (320) längs einer der ersten und/oder zweiten Achsen (X-, Y-Achse) kontrolliert um etwa 80 - 120% eines Rastermaßes benachbarter Bauteil-Aufnahmen des Trägers (320) zu verfahren, wobei
- die Empfangseinrichtung (200) dazu eingerichtet ist, relativ zu der Ablagestelle (ABS) mittels eines Linearantriebes (LA3) zumindest teilweise längs der ersten Achse (X-Achse) kontrolliert in beide Richtungen zu verfahren,
- der durch die Empfangseinrichtung (200) geführte Träger (320) mit zwei Empfangsstellen (ES1, ES2) ausgestattet ist, welche zu der Ablagestelle (ABS) für Bauteile (B) durch kontrolliertes Betätigen der Antriebe zumindest annähernd fluchtend auszurichten sind, und
- ein bildgebender Eigenschafts- und/ oder Lagesensor dazu eingerichtet ist, Eigenschaften und/oder Lage eines in Bezug auf seine Eigenschaften und/ oder seine Lage zu untersuchenden Bauteils (B) in wenigstens einer der Empfangsstellen (ES1, ES2) in der Empfangseinrichtung (200) zu liefern, und wobei
- eine Steuerung (ECU) dazu eingerichtet ist, basierend auf Bilddaten aus dem Eigenschafts- und/ oder Lagesensor Korrekturanweisungen bei Eigenschafts- und/oder Lagefehlern des Bauteils (B) zu liefern zur Veranlassung entsprechender Korrekturbewegungen durch die Antriebe (DA3, DA4, LA3) der Empfangseinrichtung (200) und/oder des in ihr geführten Trägers (320).

2. Empfangseinrichtung (200) nach Anspruch 1, wobei die zwei Empfangsstellen (ES1, ES2), zu der Ablagestelle (ABS) durch kontrolliertes Betätigen der Dreh- und/oder Linearantriebe (DA3, DA4, LA3) zumindest annähernd fluchtend auszurichten sind, und wobei die zwei Empfangsstellen (ES1, ES2) einem Rastermaß benachbarter Bauteil-Aufnahmen des Trägers (320) entsprechend zueinander zu positionieren sind.

3. Empfangseinrichtung (200) nach einem der Ansprüche 1 bis 2,
bei der der vierte Drehantrieb (DA4) dazu eingerichtet ist, durch Steuersignale aus der Steuerung (ECU) angesteuert, mittels einer mechanischen Traktion den durch die Empfangseinrichtung (200) geführten Träger (320) längs einer der ersten und/oder zweiten Achsen (X-, Y-Achse) kontrolliert um etwa 100% plus minus maximal 3%, des Rastermaßes benachbarter Bauteil-Aufnahmen des Trägers (320) zu verfahren.

4. Empfangseinrichtung (200) nach einem der Ansprüche 1 bis 3, bei der der dritte Drehantrieb (DA3) dazu eingerichtet ist, durch Steuersignale aus der Steuerung (ECU) angesteuert, in Abhängigkeit von Signalen aus dem bildgebenden Eigenschafts- und/oder Lagesensor wenigstens eine der Empfangsstellen (ES1, ES2) mit der dort befindlichen Bauteil-Aufnahme des Trägers (320) um die die Ablagestelle (ABS) enthaltende dritte Achse (Z-Achse) kontrolliert um bis zu plus minus 6 °, vorzugsweise um bis zu plus minus 3 ° zu drehen, und/oder
bei der der wenigstens eine Linearantrieb dazu eingerichtet ist, durch Steuersignale aus der Steuerung (ECU) angesteuert, die Empfangseinrichtung (200) kontrolliert um etwa plus minus maximal 20%, vorzugsweise um bis zu plus minus 3% des Rastermaßes benachbarter Bauteil-Aufnahmen des Trägers (320) längs einer der ersten, zweiten und/oder dritten Achsen (X-, Y-, Z-Achse) kontrolliert zu verfahren, und/oder bei der der Drehantrieb (DA4) dazu eingerichtet ist, den durch die Empfangseinrichtung (200) geführten Träger (320) entsprechend einem Rastermaß benachbarter Bauteil-Aufnahmen des Trägers (320) längs einer der ersten und/oder zweiten Achsen (X-, Y-Achse) vorwärts zu fördern.

5. Empfangseinrichtung (200) nach einem der Ansprüche 1 bis 4, wobei eine Absaug- und/oder Ausblaseinrichtung vorgesehen ist, um aus wenigstens einer der Empfangsstellen (ES1, ES2) in der Empfangseinrichtung (200) und/oder dem in der Empfangseinrichtung (200) geführten Träger (320) ein als schadhaft und/oder fehlerhaft platziert erkanntes Bauteil (B) zu entfernen, und/oder
wobei die Empfangseinrichtung Bauteile von einer Wendeeinrichtung (150) empfängt, deren Drehachse im Wesentlichen parallel zur Förderrichtung der Empfangseinrichtung (200) orientiert ist, oder wobei die Empfangseinrichtung (200) Bauteile (B) von einer Wendeeinrichtung (150) empfängt, deren Drehachse im Wesentlichen quer zur Förderrichtung der Empfangseinrichtung (200) orientiert ist.

6. Empfangseinrichtung (200) nach einem der Ansprüche 1 bis 5, wobei der bildgebende Eigenschafts- und/oder Lagesensor zum Ermitteln von Eigenschaften und/oder der Lage eines zu empfangenen Bauteils (B) bzw. zum Ermitteln der Lage von Empfangsstellen (ES1, ES2) in der Empfangseinrichtung (200) und/ oder darin befindlichen Bauteils (B) im Zentrum der Wendeeinrichtung (150) vorgesehen ist, und der dazu eingerichtet ist, zwischen am Umfang der Wendeeinrichtung (150) befindlichen benachbarten Aufnehmern (152) hindurch Bildeinzüge wenigstens einer der Empfangsstellen (ES1, ES2) in der Empfangseinrichtung (200) auszuführen.

7. Empfangseinrichtung (200) nach einem der Ansprüche 1 bis 5, wobei im Zentrum der Wendeeinrichtung (150) ein Umlenkspiegel oder Prisma angeordnet ist, der dem außerhalb der Wendeeinrichtung (150) angeordneten bildgebenden Eigenschafts- und/oder Lagesensor zugeordnet ist, zum Ermitteln von Eigenschaften und/ oder der Lage eines zu empfangenen Bauteils bzw. zum Ermitteln der Lage von Empfangsstellen (ES1, ES2) in der Empfangseinrichtung (200) und/oder darin befindlichen Bauteils (B) vorgesehen ist, und der dazu eingerichtet ist, zwischen am Umfang der Wendeeinrichtung (150) befindlichen benachbarten Aufnehmern (152) hindurch Bildeinzüge wenigstens einer der Empfangsstellen (ES1, ES2) in der Empfangseinrichtung (200) auszuführen.

8. Empfangseinrichtung (200) nach einem der Ansprüche 1 bis 7, wobei der Empfangseinrichtung (200) eine Absaug- und/oder Ausblaseinrichtung (340) zugeordnet ist, um aus wenigstens einer der Empfangsstellen (ES1, ES2) in der Empfangseinrichtung (200) und/oder dem in der Empfangseinrichtung (200) geführten Träger (320) ein als schadhaft und/oder fehlerhaft platziert erkanntes Bauteil (B) zu entfernen.

9. Verfahren zum Entnehmen fehlerhafter Bauteile (B) aus einer Empfangseinrichtung (200) nach Anspruch 1, wobei das Verfahren folgende Schritte aufweist:
- Erfassen eines nicht korrekt abgelegten Bauteils (B) in einer Tasche des Trägers (320) für ein Bauteil (B) an der ersten Empfangsstelle (ES1),
- Bewegen der Empfangseinrichtung (200) mittels eines Linearantriebes (LA3) längs der Förderrichtung, so dass das nicht korrekt abgelegte Bauteil (B) sich an der zweiten Empfangsstelle (ES2) befindet, ohne dabei den in der Empfangseinrichtung (200) geführten Träger (320) zu fördern,
- Absaugen des nicht korrekt abgelegten Bauteils (B) an der zweiten Empfangsstelle (ES2) aus der Tasche für ein Bauteil (B);
- Zurückbewegen der Empfangseinrichtung (200) mittels des Linearantriebes (LA3) entgegen der Förderrichtung, so dass eine leere Tasche für ein Bauteil (B) sich an der ersten Empfangsstelle (ES1) befindet, ohne dabei den in der Empfangseinrichtung (200) geführten Träger (320) zu fördern,
Ablegen eines Bauteils (B) in der Tasche des Trägers (320) an der ersten Empfangsstelle (ES1).

## Claims

1. A reception device (200) for components (B) which is adapted, relative to a deposit point (ABS),
- to rotate in a controlled manner at least partly about a third axis (Z-axis) containing the deposit point (ABS) by means of a rotary drive (DA3),
- to move in a controlled manner at least partly along one of the first, second and/or third axes (X-, Y-, Z-axis) by means of at least one linear drive (LA4), and
- to move a carrier (320) guided by the reception device (200) in a con-trolled manner, by means of a rotary drive (DA4), along one of the first and/or second axes (X-, Y-axis) by approximately from 80 to 120% of a spacing of adjacent component receivers of the carrier (320), wherein
- the reception device (200) is adapted to move in a controlled manner relative to the deposit point (ABS) at least partly along the first axis (X-axis) in both directions by means of a linear drive (LA3),
- the carrier (320) guided by the reception device (200) is equipped with two reception points (ES1, ES2) which are to be oriented at least approximately in alignment with the deposit point (ABS) for components (B) by controlled operation of the drives, and
- an imaging property and/or position sensor is adapted to provide proper-ties and/or the position of a component (B) in at least one of the reception points (ES1, ES2) in the reception device (200) that is to be examined in respect of its properties and/or its position, and wherein,
- a controller (ECU) is adapted, based on image data from the property and/or position sensor, to provide correction instructions in the event of property defects and/or position errors of the component (B) in order to effect corresponding correction movements by the drives (DA3, DA4, LA3) of the reception device (200) and/or of the carrier (320) guided therein.

2. The reception device (200) as claimed in claim 1, wherein the two reception points (ES1, ES2) are to be oriented at least approximately in alignment with the deposit point (ABS) by controlled operation of the rotary and/or linear drives (DA3, DA4, LA3), and wherein the two reception points (ES1, ES2) are to be positioned relative to one another according to a spacing of adjacent component receivers of the carrier (320).

3. The reception device (200) as claimed in either claim 1 or claim 2,
wherein the fourth rotary drive (DA4) is adapted, under the control of control signals from the controller (ECU), to move the carrier (320) guided by the reception device (200) in a controlled manner, by means of mechanical traction, along one of the first and/or second axes (X-, Y-axis) by approximately 100% plus minus not more than 3% of the spacing of adjacent component receivers of the carrier (320).

4. The reception device (200) as claimed in any one of claims 1 to 3, wherein the third rotary drive (DA3) is adapted, under the control of control signals from the controller (ECU) and in dependence on signals from the imaging property and/or position sensor, to rotate at least one of the reception points (ES1, ES2) with the component receiver of the carrier (320) situated there in a controlled manner about the third axis (Z-axis) containing the deposit point (ABS) by up to plus minus 6·°, preferably by up to plus minus 3·°, and/or
wherein the at least one linear drive is adapted, under the control of control signals from the controller (ECU), to move the reception device (200) in a controlled manner along one of the first, second and/or third axes (X-, Y-, Z-axis) in a controlled manner by approximately plus minus not more than 20%, preferably by up to plus minus 3%, of the spacing of adjacent component receivers of the carrier (320), and/or wherein the rotary drive (DA4) is adapted to feed the carrier (320) guided by the reception device (200) forwards along one of the first and/or second axes (X-, Y-axis) according to a spacing of adjacent component receivers of the carrier (320).

5. The reception device (200) as claimed in any one of claims 1 to 4, wherein a suction and/or blow-off device is provided for removing a component (B) identified as being damaged and/or incorrectly placed from at least one of the reception points (ES1, ES2) in the reception device (200) and/or the carrier (320) guided in the reception device (200), and/or
wherein the reception device receives components from a turning device (150) whose axis of rotation is oriented substantially parallel to the feed direction of the reception device (200), or wherein the reception device (200) receives components (B) from a turning device (150) whose axis of rotation is oriented substantially transversely to the feed direction of the reception device (200).

6. The reception device (200) as claimed in any one of claims 1 to 5, wherein the imaging property and/or position sensor for determining properties and/or the position of a component (B) to be received or for determining the position of reception points (ES1, ES2) in the reception device (200) and/or of a component (B) situated therein is provided in the center of the turning device (150), which sensor is adapted to perform image acquisitions of at least one of the reception points (ES1, ES2) in the reception device (200) between adjacent pick-up elements (152) situated at the periphery of the turning device (150).

7. The reception device (200) as claimed in any one of claims 1 to 5, wherein there is arranged in the center of the turning device (150) a deflection mirror or prism which is associated with the imaging property and/or position sensor arranged outside the turning device (150), for determining properties and/or the position of a component to be received or for determining the position of reception points (ES1, ES2) in the reception device (200) and/or of a component (B) situated therein, and which is adapted to perform image acquisitions of at least one of the reception points (ES1, ES2) in the reception device (200) between adjacent pick-up elements (152) situated at the periphery of the turning device (150).

8. The reception device (200) as claimed in any one of claims 1 to 7, wherein the reception device (200) has an associated suction and/or blow-off device (340) for removing a component (B) identified as being damaged and/or incorrectly placed from at least one of the reception points (ES1, ES2) in the reception device (200) and/or from the carrier (320) guided in the reception device (200).

9. A method for removing faulty components (B) from a reception device (200) as claimed in claim 1, wherein the method comprises the following steps:
- detecting an incorrectly deposited component (B) in a pocket of the carrier (320) for a component (B) at the first reception point (ES1),
- moving the reception device (200) by means of a linear drive (LA3) in the feed direction so that the incorrectly deposited component (B) is situated at the second reception point (ES2), without thereby feeding the carrier (320) guided in the reception device (200),
- extracting by suction the incorrectly deposited component (B) at the second reception point (ES2) from the pocket for a component (B);
- moving the reception device (200) by means of the linear drive (LA3) back contrary to the feed direction, so that an empty pocket for a component (B) is situated at the first reception point (ES1), without thereby feeding the carrier (320) guided in the reception device (200),
depositing a component (B) in the pocket of the carrier (320) at the first reception point (ES1).

## Revendications

1. Dispositif de réception (200) pour composants (B), conçu pour, par rapport à un point de dépôt (ABS),
- tourner de façon contrôlée au moins partiellement autour d'un troisième axe (axe Z) contenant le point de dépôt (ABS) au moyen d'un organe d'entraînement rotatif (DA3),
- se déplacer de façon contrôlée au moins partiellement le long d'un desdits premier, deuxième et/ou troisième axes (axe X, axe Y, axe Z) au moyen d'au moins un organe d'entraînement linéaire (LA4), et
- déplacer de façon contrôlée, au moyen d'un organe d'entraînement rotatif (DA4), un support (320) porté par le dispositif de réception (200) le long d'un desdits premier et/ou deuxième axes (axe X, axe Y) d'environ 80 à 120 % d'un pas entre des logements de composant adjacents du support (320), dans lequel
- le dispositif de réception (200) est conçu pour se déplacer de façon contrôlée dans les deux sens au moins partiellement le long du premier axe (axe X), par rapport au point de dépôt (ABS), au moyen d'un organe d'entraînement linéaire (LA3),
- le support (320) porté par le dispositif de réception (200) est doté de deux points de réception (ES1, ES2) destinés à être alignés au moins approximativement sur le point de dépôt (ABS) pour composants (B) en actionnant de façon contrôlée les organes d'entraînement, et
- un capteur de propriétés et/ou de position générateur d'images est conçu pour fournir, au niveau d'au moins l'un des points de réception (ES1, ES2) dans le dispositif de réception (200), les propriétés et/ou la position d'un composant (B) dont les propriétés et/ou la position est (sont) à déterminer, et dans lequel
- un organe de commande (ECU) est conçu pour fournir des instructions de correction sur la base d'images provenant du capteur de propriétés et/ou de position en cas d'erreurs de propriétés et/ou de position du composant (B), afin de générer des mouvements de correction correspondants à l'aide des organes d'entraînement (DA3, DA4, LA3) du dispositif de réception (200) et/ou du support (320) porté par ce dernier.

2. Dispositif de réception (200) selon la revendication 1, dans lequel les deux points de réception (ES1, ES2) doivent être alignés au moins approximativement sur le point de dépôt (ABS) en actionnant de façon contrôlée les organes d'entraînement rotatif et/ou linéaire (DA3, DA4, LA3), et dans lequel les deux points de réception (ES1, ES2) sont positionnés l'un par rapport à l'autre conformément à un pas entre les logements de composant adjacents du support (320).

3. Dispositif de réception (200) selon la revendication 1 ou 2, dans lequel le quatrième organe d'entraînement rotatif (DA4) est conçu pour, piloté par des signaux de commande émis par l'organe de commande (ECU), déplacer de façon contrôlée, au moyen d'une traction mécanique, le long d'un desdits premier et/deuxième axes (axe X, axe Y) le support (320) porté par le dispositif de réception (200) d'environ 100 %, ± 3 % au maximum, du pas entre des logements de composant adjacents du support (320).

4. Dispositif de réception (200) selon l'une des revendications 1 à 3, dans lequel le troisième organe d'entraînement rotatif (DA3) est conçu pour, piloté par des signaux de commande émis par l'organe de commande (ECU) et en fonction de signaux émis par le capteur de propriétés et/ou de position générateur d'images, tourner de façon contrôlée au moins l'un des points de réception (ES1, ES2) comprenant le logement de composant du support (320), qui s'y trouve, de jusqu'à ± 6°, de préférence de jusqu'à ± 3° autour du troisième axe (axe Z) contenant le point de dépôt (ABS), et/ou
dans lequel ledit au moins un organe d'entraînement linéaire est conçu pour, piloté par des signaux de commande émis par l'organe de commande (ECU), déplacer le dispositif de réception (200) de façon contrôlée le long d'un desdits premier, deuxième et/ou troisième axes (axe X, axe Y, axe Z) d'environ ± 20 % au maximum, de préférence de ± 3 % du pas entre les logements de composant adjacents du support (320) et/ou
dans lequel l'organe d'entraînement rotatif (DA4) est conçu pour faire avancer le long d'un desdits premier et/deuxième axes (axe X, axe Y) le support (320) porté par le dispositif de réception (200) conformément à un pas entre les logement de composant adjacents du support (320).

5. Dispositif de réception (200) selon l'une des revendications 1 à 4, dans lequel un dispositif d'aspiration et/ou de soufflage est prévu afin de retirer d'au moins l'un des points de réception (ES1, ES2) dans le dispositif de réception (200) et/ou du support (320) porté par le dispositif de réception (200) un composant (B) identifié comme étant positionné de manière défectueuse et/ou incorrecte, et/ou
dans lequel le dispositif de réception réceptionne des composants provenant d'un dispositif de retournement (150) dont l'axe de rotation est orienté essentiellement parallèlement à la direction de transport du dispositif de réception (200), ou dans lequel le dispositif de réception (200) réceptionne des composants (B) provenant d'un dispositif de retournement (150) dont l'axe de rotation est orienté essentiellement transversalement à la direction de transport du dispositif de réception (200).

6. Dispositif de réception (200) selon l'une des revendications 1 à 5, dans lequel le capteur de propriétés et/ou de position générateur d'images destiné à déterminer des propriétés et/ou la position d'un composant (B) à réceptionner ou à déterminer la position de points de réception (ES1, ES2) dans le dispositif de réception (200) et/ou de composants (B) s'y trouvant est prévu au centre du dispositif de retournement (150), et dans lequel ledit capteur est conçu pour procéder à des acquisitions d'images d'au moins l'un des points de réception (ES1, ES2) dans le dispositif de réception (200) entre des éléments de réception (152) adjacents situés sur le pourtour du dispositif de retournement (150).

7. Dispositif de réception (200) selon l'une des revendications 1 à 5, dans lequel au centre du dispositif de retournement (150) est disposé un miroir déflecteur ou un prisme qui est associé au capteur de propriétés et/ou de position générateur d'images disposé à l'extérieur du dispositif de retournement (150), en vue de déterminer des propriétés et/ou la position d'un composant à réceptionner ou de déterminer la position de points de réception (ES1, ES2) dans le dispositif de réception (200) et/ou de composants (B) s'y trouvant, et dans lequel ledit miroir est conçu pour procéder à des acquisitions d'images d'au moins l'un des points de réception (ES1, ES2) dans le dispositif de réception (200) entre des éléments de réception (152) adjacents situés sur le pourtour du dispositif de retournement (150).

8. Dispositif de réception (200) selon l'une des revendications 1 à 7, dans lequel un dispositif d'aspiration et/ou de soufflage (340) est associé au dispositif de réception (200), afin de retirer d'au moins l'un des points de réception (ES1, ES2) dans le dispositif de réception (200) et/ou du support (320) porté par le dispositif de réception (200) un composant (B) identifié comme étant positionné de manière défectueuse et/ou incorrecte.

9. Procédé pour retirer des composants (B) défectueux d'un dispositif de réception (200) selon la revendication 1, dans lequel le procédé comporte les étapes suivantes :
- détection d'un composant (B) déposé de façon incorrecte dans une poche du support (320) pour un composant (B) au niveau du premier point de réception (ES1),
- déplacement du dispositif de réception (200) dans le sens de transport au moyen d'un organe d'entraînement linéaire (LA3), de manière à ce que le composant (B) déposé de façon incorrecte se trouve au niveau du deuxième point de réception (ES2) sans déplacer pour autant le support (320) porté par le dispositif de réception (200),
- aspiration du composant (B) déposé de façon incorrecte hors de la poche pour un composant (B) au niveau du deuxième point de réception (ES2) ;
- déplacement en arrière du dispositif de réception (200) dans le sens inverse au sens de transport au moyen de l'organe d'entraînement linéaire (LA3), de manière à ce qu'une poche vide pour un composant (B) se trouve au niveau du premier point de réception (ES1) sans déplacer pour autant le support (320) porté dans le dispositif de réception (200),
- dépôt d'un composant (B) dans la poche du support (320) au niveau du premier point de réception (ES1).
